# EUROPEAN PATENT APPLICATION

(11) **EP 4 739 045 A1**
(43) Date of publication of application: **06.05.2026**
(21) Application number: 25183392.7
(22) Date of filing: 17.06.2025
(51) Int. Cl.: H10H 29/14, H10H 29/30, H10H 29/80

(54) **LIGHT-EMITTING DEVICE AND DISPLAY DEVICE INCLUDING THE SAME**

(30) Priority: 29.10.2024 KR 20240149925
(71) Applicant: Samsung Electronics Co., Ltd., Suwon-si, Gyeonggi-do 16677 (KR)
(72) Inventor: Oh, Youngtek, 16677 Suwon-si (KR); Kim, Joosung, 16678 Suwon-si (KR); Park, Joonyong, 16678 Suwon-si (KR); Shin, Dongchul, 16677 Suwon-si (KR); Han, Joohun, 16677 Suwon-si (KR); Hwang, Kyungwook, 16677 Suwon-si (KR); Hwang, Junsik, 16678 Suwon-si (KR); Song, Sanghoon, 16678 Suwon-si (KR); Yu, Minchul, 16678 Suwon-si (KR)
(74) Representative: Arnold & Siedsma

(57) **Abstract**

A light-emitting device may comprise a light-emitting unit including light-emitting structures that are sequentially stacked, wherein each of the light-emitting structures includes a first conductivity-type semiconductor layer, an active layer, and a second conductivity-type semiconductor layer that are sequentially stacked. The light-emitting device may further include individual electrodes in contact with the first conductivity-type semiconductor layers of the light-emitting structures and on a lower surface of the light-emitting unit. At least one, preferably at least two of the individual electrodes may have a conductive via structure. A common electrode, which is in contact with side surfaces of the second conductivity-type semiconductor layers of the light-emitting structures, may be arranged on a side surface of the light-emitting unit. Side surfaces of the first conductivity-type semiconductor layers and the active layers of the light-emitting structures may be insulated from the common electrode by an insulating layer.

## Description

TECHNICAL FIELD The present disclosure relates to a light-emitting device and a display device including the same.

BACKGROUND Light-emitting devices such as, for example, light-emitting diodes (LEDs), are known as next-generation light sources having advantages such as long lifespan, low power consumption, fast response time, and environmental friendliness compared to related-art light sources. In light of these advantages, the industrial demand for light-emitting devices is increasing. LEDs are typically applied and used in various products such as lighting devices or display devices.

Recently, ultra-small LEDs on the microscale or nanoscale have been developed. Such devices are referred to as micro-LEDs. Micro-LEDs have been applied to relatively large display devices such as televisions, and furthermore, their application to small display devices, such as displays for augmented reality (AR) devices, has been attempted. Micro-LEDs applied to small display devices are significantly small on the order of a few micrometers, making it difficult to secure a large light emission area. In particular, in micro-LEDs where red-green-blue (RGB) sub-pixels are vertically arranged, the light emission area is reduced due to electrodes for driving the respective sub-pixels, which may lower the light emission efficiency of the micro-LEDs.

### SUMMARY

According to embodiments of the present disclosure, a light-emitting device with improved light emission efficiency and a display device including the light-emitting device are provided.

According to a first aspect, a light-emitting device may be provided and include: a light-emitting unit including a first light-emitting structure, a second light-emitting structure, and a third light-emitting structure that are sequentially stacked and configured to emit light of respective, different wavelengths, wherein each of the first light-emitting structure, the second light-emitting structure, and the third light-emitting structure includes a first conductivity-type semiconductor layer, an active layer, and a second conductivity-type semiconductor layer that are sequentially stacked; a first individual electrode on a lower surface of the light-emitting unit and in contact with the first conductivity-type semiconductor layer of the first light-emitting structure; a second individual electrode on the lower surface of the light-emitting unit and in contact with the first conductivity-type semiconductor layer of the second light-emitting structure; a third individual electrode on the lower surface of the light-emitting unit and in contact with the first conductivity-type semiconductor layer of the third light-emitting structure; a common electrode on a side surface of the light-emitting unit and in contact with side surfaces of the second conductivity-type semiconductor layer of each of the first light-emitting structure, the second light-emitting structure, and the third light-emitting structure; and an insulating layer that insulates, from the common electrode, side surfaces of the first conductivity-type semiconductor layer and the active layer of each of the first light-emitting structure, the second light-emitting structure, and the third light-emitting structure, wherein at least two from among the first individual electrode, the second individual electrode, and the third individual electrode include a conductive via structure.

According to one or more embodiments of the present disclosure, the side surfaces of the first conductivity-type semiconductor layer and the active layer of each of the first light-emitting structure, the second light-emitting structure, and the third light-emitting structure may be concavely stepped inward from side surfaces of the second conductivity-type semiconductor layer of each of the first light-emitting structure, the second light-emitting structure, and the third light-emitting structure.

According to one or more embodiments of the present disclosure, a length by which the side surfaces of the first conductivity-type semiconductor layer and the active layer of each of the first light-emitting structure, the second light-emitting structure, and the third light-emitting structure are stepped from the side surface of the second conductivity-type semiconductor layer of each of the first light-emitting structure, the second light-emitting structure, and the third light-emitting structure may be 0.5 µm or less.

According to one or more embodiments of the present disclosure, the common electrode may surround the side surface of the light-emitting unit.

According to one or more embodiments of the present disclosure, the common electrode may extend on to an upper surface of the light-emitting unit.

According to one or more embodiments of the present disclosure, the common electrode may include a transparent electrode material.

According to one or more embodiments of the present disclosure, the first individual electrode may include a first electrode pad that is in contact with a lower surface of the first conductivity-type semiconductor layer of the first light-emitting structure, wherein the second individual electrode may include: a second electrode pad that is on the lower surface of the light-emitting unit; and a conductive via that electrically connects the second electrode pad to the first conductivity-type semiconductor layer of the second light-emitting structure, and wherein the third individual electrode may include: a third electrode pad that is on the lower surface of the light-emitting unit; and a conductive via that electrically connects the third electrode pad to the first conductivity-type semiconductor layer of the third light-emitting structure. For the sake of conciseness, the conductive via of the second individual electrode will be referred to as the "second conductive via", and the conductive via of the third individual electrode will be referred to as the "third conductive via".

According to one or more embodiments of the present disclosure, the first individual electrode may include: a first electrode pad on the lower surface of the light-emitting unit; and a first conductive via that electrically connects the first electrode pad to the first conductivity-type semiconductor layer of the first light-emitting structure; the second individual electrode may include: a second electrode pad on the lower surface of the light-emitting unit; and a second conductive via that electrically connects the second electrode pad to the first conductivity-type semiconductor layer of the second light-emitting structure; and the third individual electrode may include: a third electrode pad on the lower surface of the light-emitting unit; and a third conductive via that electrically connects the third electrode pad to the first conductivity-type semiconductor layer of the third light-emitting structure.

According to one or more embodiments of the present disclosure, the light-emitting device may further include: a reflective layer that surrounds the side surface of the light-emitting unit; and a passivation layer that insulates the common electrode from the reflective layer.

According to one or more embodiments of the present disclosure, the side surface of the light-emitting unit may be parallel to a direction in which the first light-emitting structure, the second light-emitting structure, and the third light-emitting structure are stacked.

According to one or more embodiments of the present disclosure, the side surface of the light-emitting unit may be inclined such as to gradually expand outward from the first light-emitting structure toward the third light-emitting structure.

According to one or more embodiments of the present disclosure, the light-emitting device may further include a scattering pattern on an upper surface of the light-emitting unit.

According to one or more embodiments of the present disclosure, the light-emitting device may further include a lens on an upper surface of the light-emitting unit.

According to one or more embodiments of the present disclosure, the third light-emitting structure may be configured to emit red light.

According to one or more embodiments of the present disclosure, the first light-emitting structure and the second light-emitting structure may be configured to emit blue light and green light, respectively.

According to a second aspect, a light-emitting device may be provided and include: a light-emitting unit including a plurality of light-emitting structures that are sequentially stacked, wherein each of the plurality of light-emitting structures includes a first conductivity-type semiconductor layer, an active layer, and a second conductivity-type semiconductor layer that are sequentially stacked; a plurality of individual electrodes that are on a lower surface of the light-emitting unit and are in contact with the first conductivity-type semiconductor layer of each of the plurality of light-emitting structures, respectively, wherein at least two of the plurality of individual electrodes include conductive via structures; a common electrode on a side surface of the light-emitting unit, the common electrode in contact with side surfaces of the second conductivity-type semiconductor layer of each of the plurality of light-emitting structures; and an insulating layer that insulates, from the common electrode, side surfaces of the first conductivity-type semiconductor layer and the active layer of each of the plurality of light-emitting structures.

According to one or more embodiments of the present disclosure, an uppermost light-emitting structure from among the plurality of light-emitting structures may be configured to emit red light.

According to one or more embodiments of the present disclosure, the side surfaces of the first conductivity-type semiconductor layer and the active layer of each of the plurality of light-emitting structures may be concavely stepped inward from the side surfaces of the second conductivity-type semiconductor layer of each of the plurality of light-emitting structures.

According to one or more embodiments of the present disclosure, the light-emitting device of claim 16, may further include: a reflective layer that surrounds the side surface of the light-emitting unit; and a passivation layer that insulates the common electrode from the reflective layer.

According to a third aspect, a display device may be provided and include a display panel including a plurality of light-emitting devices as described above and a driver circuit configured to switch the plurality of light-emitting devices on and off. The display device may further include a controller configured to input on-off switching signals for the plurality of light-emitting devices to the driver circuit according to an image signal. More precisely, each of the plurality of light-emitting devices may comprise a light-emitting unit comprising a plurality of light-emitting structures that are sequentially stacked, wherein each of the plurality of light-emitting structures comprises a first conductivity-type semiconductor layer, an active layer, and a second conductivity-type semiconductor layer that are sequentially stacked; a plurality of individual electrodes that are on a lower surface of the light-emitting unit, wherein each individual electrode from the plurality of individual electrodes corresponds to a light-emitting structure from the plurality of light-emitting structures, and wherein each individual electrode from the plurality of individual electrodes is in contact with the first conductivity-type semiconductor layer of the corresponding light-emitting structure, wherein at least one individual electrode, preferably at least two individual electrodes, from the plurality of individual electrodes, comprises a conductive via structure; a common electrode on a side surface of the light-emitting unit, wherein the common electrode is in contact with side surfaces of the second conductivity-type semiconductor layer of each of the plurality of light-emitting structures; and an insulating layer that insulates, from the common electrode, side surfaces of the first conductivity-type semiconductor layer and the active layer of each of the plurality of light-emitting structures.

Additional aspects of the present disclosure will be set forth in part in the description which follows and, in part, will be apparent from the description, or may be learned by practice of the example embodiments of the present disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of a light-emitting device according to an embodiment;
FIG. 2 is a schematic cross-sectional view of a light-emitting unit illustrated in FIG. 1;
FIG. 3 is a schematic cross-sectional view of a light-emitting device according to an embodiment;
FIG. 4 is a schematic cross-sectional view of a light-emitting device according to an embodiment;
FIG. 5 is a schematic cross-sectional view of a light-emitting device according to an embodiment;
FIGS. 6, 7, and 8 illustrate examples of a planar arrangement of first, second, and third individual electrodes;
FIGS. 9A to 9M illustrate an example of a method of manufacturing the light-emitting devices illustrated in FIGS. 1 and 3;
FIGS. 10A to 10L illustrate an example of a method of manufacturing the light-emitting devices illustrated in FIGS. 4 and 5;
FIG. 11 is a schematic diagram of an embodiment of a display device;
FIG. 12 is a block diagram of an embodiment of an electronic device including a display;
FIG. 13 illustrates an embodiment of a mobile device as an example application of an electronic device;
FIG. 14 illustrates an embodiment of an automotive head-up display device as an example application of an electronic device;
FIG. 15 illustrates an embodiment of augmented reality glasses or virtual reality glasses as an example application of an electronic device;
FIG. 16 illustrates an embodiment of a large signage display as an example application of an electronic device; and
FIG. 17 illustrates an embodiment of a wearable display as an example application of an electronic device.

### DETAILED DESCRIPTION

Reference will now be made in detail to non-limiting example embodiments of the present disclosure, examples of which are illustrated in the accompanying drawings, wherein like reference numerals refer to like elements throughout. In this regard, embodiments of the present disclosure may have different forms and should not be construed as being limited to the descriptions set forth herein. Accordingly, the example embodiments are merely described below, by referring to the figures, to explain example aspects of the present disclosure. As used herein, the term "and/or" includes any and all combinations of one or more of the associated listed items.

Recently, the technology of applying light-emitting devices such as, for example, micro-light-emitting diodes (LEDs), to displays has advanced significantly, and televisions using micro-LEDs have begun to be released. Furthermore, attempts have been made to apply micro-LEDs to augmented reality devices. In displays for augmented reality devices, unlike in displays for televisions, significantly small micro-LED display chips (or panels) may be fabricated monolithically at the wafer level, without the process of transferring micro-LEDs. In displays for televisions, the size of a single pixel may be tens to hundreds of micrometers, but in small or ultra-small displays, such as displays for augmented reality devices, the size of a single pixel may be significantly small, on the order of a few micrometers.

To display color images in a display, one pixel (color pixel) may include red-green-blue (RGB) sub-pixels. There are two types of arrangement structures for RGB sub-pixels: horizontal arrangement and vertical arrangement. In the horizontal arrangement structure, RGB sub-pixels are arranged horizontally, and in the vertical arrangement structure, RGB sub-pixels are arranged vertically. In the horizontal arrangement structure, each of sub-pixels may be referred to as a micro-LED. In the vertical arrangement structure, each micro-LED may be a monolithic RGB micro-LED in which RGB sub-pixels are integrated.

For a color pixel of a given size, the horizontal arrangement structure may include smaller sub-pixels compared to the vertical arrangement structure, resulting in a high difficulty in horizontal processing. In the vertical arrangement structure, sub-pixels may be arranged vertically, and thus, the difficulty of vertical processing may be high. However, in the vertical arrangement structure, sub-pixels may be made larger compared to the sub-pixels in the horizontal arrangement structure, resulting in higher efficiency (e.g., external quantum efficiency (EQE)) compared to the horizontal arrangement structure.

When fabricating an RGB micro-LED chip with a vertical arrangement structure, conductive vias that partially or fully penetrate sub-pixels may be used to form electrodes for driving the respective sub-pixel. For example, six electrodes may be used to drive RGB sub-pixels, five of which may be implemented by conductive vias. As the number of conductive vias increases, the light emission area of the micro-LEDs may decrease. In small or ultra-small displays, such as displays for augmented reality devices, the pixel size may only be a few micrometers, and thus, when there are many conductive vias, it may be difficult to secure a sufficient light emission area. Therefore, in order to secure a large light emission area, it may be beneficial to reduce the number of conductive vias.

According to embodiments of the present disclosure, a light-emitting device may be provided that may be, for example, a vertical RGB micro-LED, with improved light emission efficiency by reducing the number of conductive vias to secure a sufficient light emission area, and a display device may be provided that employs the light-emitting device. To this end, p-electrodes (or n-electrodes) of a plurality of sub-pixels may be formed as a common electrode. The common electrode may be formed on side surfaces of the sub-pixels to maximize the pixel size. Accordingly, the number of conductive vias may be reduced, making it possible to secure a light emission area, and thus increasing light emission efficiency and reducing power consumption.

Hereinafter, non-limiting example embodiments of light-emitting devices and display devices employing the same will be described in detail with reference to the accompanying drawings. In the drawings, like reference numerals refer to like elements, and sizes of elements in the drawings may be exaggerated for clarity and convenience of description. Embodiments described below are merely examples, and various modifications are possible from the embodiments.

Hereinafter, an expression "on" used herein may include not only "immediately on in a contact manner" but also "on in a non-contact manner". The singular expression also includes the plural meaning as long as it is not inconsistent with the context. In addition, when an element is referred to as "including" (or "comprising") a component, the element may additionally include other components rather than excluding other components as long as there is no particular opposing recitation.

The term "the" and other demonstratives similar thereto should be understood to include a singular form and plural forms. Operations of a method described herein may be performed in any suitable order unless otherwise indicated herein or otherwise clearly contradicted by context, and the present disclosure is not limited to the described order of the operations.

Line connections or connection members between elements depicted in the drawings represent functional connections and/or physical or circuit connections by way of example, and in actual applications, they may be replaced or embodied with various suitable additional functional connections, physical connections, or circuit connections.

The use of any and all examples, or example language provided herein, is intended merely to describe example embodiments of the present disclosure in more detail, and does not pose a limitation on the scope of the present disclosure unless otherwise stated.

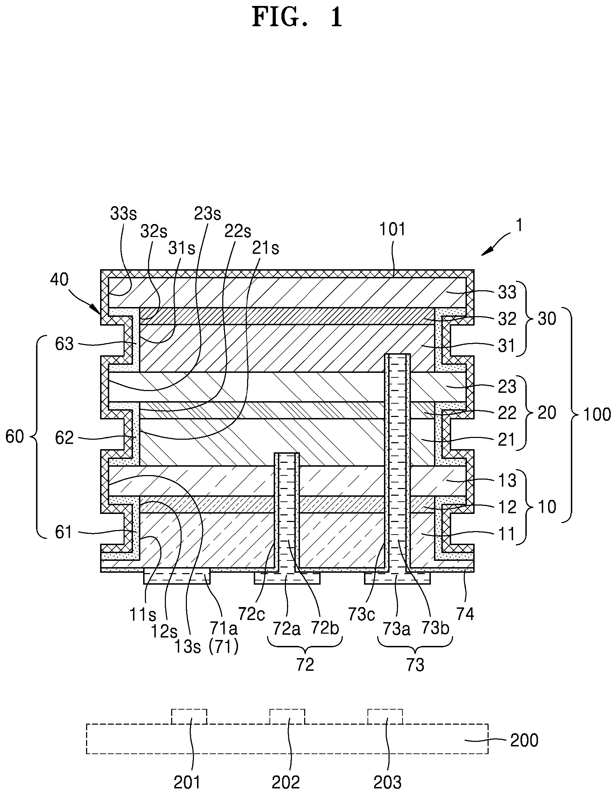

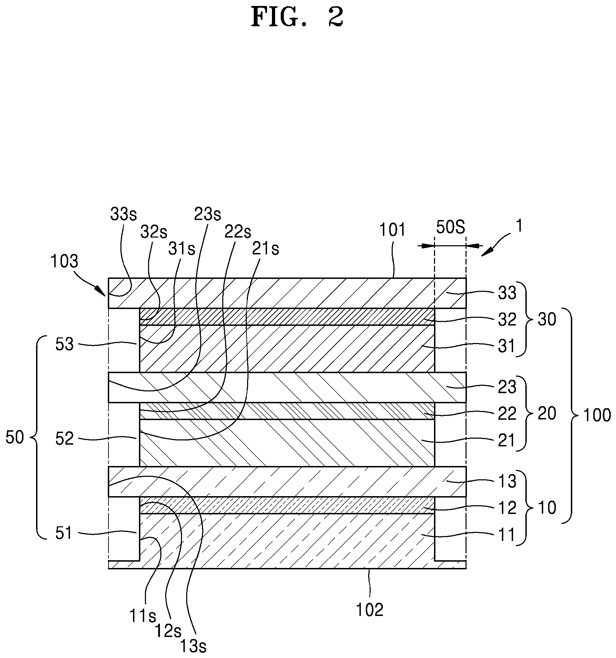

FIG. 1 is a schematic cross-sectional view of a light-emitting device 1 according to an embodiment. FIG. 2 is a schematic cross-sectional view of a light-emitting unit 100 illustrated in FIG. 1. The light-emitting device 1 of the present embodiment may be a vertical stack-type light-emitting device including a plurality of sub-pixels that are vertically stacked. The light-emitting device 1 may be, for example, a micro-LED.

Referring to FIGS. 1 and 2, the light-emitting device 1 may include the light-emitting unit 100 having a plurality of vertically stacked light-emitting structures, and a plurality of electrodes for driving the plurality of light-emitting structures. The light-emitting device 1 may correspond to one pixel in a display device, and the plurality of light-emitting structures may correspond to vertically stacked sub-pixels forming one pixel. Each of the plurality of light-emitting structures may include a first conductivity-type semiconductor layer, an active layer, and a second conductivity-type semiconductor layer, which are sequentially stacked. The plurality of electrodes may include a common electrode 40 that is common to the plurality of light-emitting structures and a plurality of individual electrodes corresponding to the plurality of light-emitting structures, respectively. The plurality of individual electrodes may be provided on a lower surface 102 of the light-emitting unit 100, and may be in contact with the first conductivity-type semiconductor layers of the plurality of light-emitting structures. At least some of the plurality of individual electrodes may have conductive via structures that penetrate the other light-emitting structures. The common electrode 40 may be provided on a side surface 103 of the light-emitting unit 100, and may be in contact with side surfaces of the second conductivity-type semiconductor layers of the plurality of light-emitting structures. Insulating layers 60 may be provided on side surfaces of the first conductivity-type semiconductor layers and the active layers of the plurality of light-emitting structures, to insulate the side surfaces from the common electrode.

The light-emitting unit 100 may be formed of a group III-V nitride semiconductor material. The group III-V nitride semiconductor material may include, for example, GaN, InGaN, AlInGaN, AlGaInP, etc. For example, the light-emitting unit 100 may be formed of a GaN-based semiconductor material. Each of the plurality of light-emitting structures may have a structure in which the first conductivity-type semiconductor layer, the active layer having a quantum well structure, and the second conductivity-type semiconductor layer are sequentially stacked. In the active layer, the band gap energy may be controlled according to the composition ratio of indium (In) in a material layer containing indium (In), such that the light emission wavelength range is determined.

For example, the plurality of light-emitting structures may emit light of different wavelengths. In the present embodiment, the plurality of light-emitting structures may include a first light-emitting structure 10, a second light-emitting structure 20, and a third light-emitting structure 30 that are sequentially stacked. The first light-emitting structure 10 may be a lower layer of the light-emitting unit 100. The second light-emitting structure 20 may be stacked on the first light-emitting structure 10, and the third light-emitting structure 30 may be stacked on the second light-emitting structure 20. The third light-emitting structure 30 may be an upper layer of the light-emitting unit 100.

The first light-emitting structure 10 may include a first conductivity-type semiconductor layer 11, an active layer 12 having a quantum well structure, and a second conductivity-type semiconductor layer 13 that are sequentially stacked. The first conductivity-type semiconductor layer 11 may be a semiconductor layer doped with first type impurities such as, for example, a GaN layer. The active layer 12 may be a layer that emits light through electron-hole recombination. The active layer 12 may be grown on the first conductivity-type semiconductor layer 11. The active layer 12 may have a quantum well structure. For example, the active layer 12 may have a single-quantum well or multi-quantum well structure formed by periodically changing the x, y, and z values in AlₓGa_{y}In_{z}N to adjust the band gap. For example, a quantum well layer and a barrier layer may be paired in the form of InGaN/GaN, InGaN/InGaN, InGaN/AlGaN, or InGaN/InAlGaN to form a quantum well structure, and the band gap energy may be controlled according to the composition ratio of indium (In) in a material layer including indium (In), such that the light emission wavelength range is adjusted. The second conductivity-type semiconductor layer 13 may be formed on the active layer 12. The second conductivity-type semiconductor layer 13 may be a semiconductor layer doped with second type impurities such as, for example, a GaN layer. For example, the first type impurities may be n-type impurities, and the second type impurities may be p-type impurities. Conversely, the first type impurities may be p-type impurities and the second type impurities may be n-type impurities. As n-type impurities, Si, Ge, Se, Te, etc., may be used. As p-type impurities, Mg, Zn, Be, etc., may be used. In the present embodiment, a case will be described in which the first type impurities are n-type impurities and the second type impurities are p-type impurities. In this case, the first conductivity-type semiconductor layer 11 may be an n-GaN layer, and the second conductivity-type semiconductor layer 13 may be a p-GaN layer.

The second light-emitting structure 20 may include a first conductivity-type semiconductor layer 21, an active layer 22 having a quantum well structure, and a second conductivity-type semiconductor layer 23 that are sequentially stacked. The description of the first conductivity-type semiconductor layer 11, the active layer 12 having a quantum well structure, and the second conductivity-type semiconductor layer 13 of the first light-emitting structure 10 may be applied to the first conductivity-type semiconductor layer 21, the active layer 22 having a quantum well structure, and the second conductivity-type semiconductor layer 23 of the second light-emitting structure 20, respectively. The third light-emitting structure 30 may include a first conductivity-type semiconductor layer 31, an active layer 32 having a quantum well structure, and a second conductivity-type semiconductor layer 33 that are sequentially stacked. The description of the first conductivity-type semiconductor layer 11, the active layer 12 having a quantum well structure, and the second conductivity-type semiconductor layer 13 of the first light-emitting structure 10 may be applied to the first conductivity-type semiconductor layer 31, the active layer 32 having a quantum well structure, and the second conductivity-type semiconductor layer 33 of the third light-emitting structure 30, respectively.

For example, the third light-emitting structure 30 positioned on the light output side of the light-emitting device 1, that is, forming the uppermost layer of the light-emitting unit 100, may emit red light (e.g., light in the wavelength range of 630±20 nm). The light emission efficiency of the third light-emitting structure 30 that emits red light may be lower than the light emission efficiency of light-emitting structures that emit light of other colors. By placing the third light-emitting structure 30 that emits red light at the uppermost layer of the light-emitting unit 100, the formation of via holes for forming a conductive via structure in the active layer 32 of the third light-emitting structure 30 may be avoided. Thus, it is possible to prevent a decrease in the light emission efficiency of the third light-emitting structure 30 that emits red light. The first light-emitting structure 10 and the second light-emitting structure 20 may emit, for example, blue light (e.g., light in the wavelength range of 460±20 nm) and green light (e.g., light in the wavelength range of 530±20 nm), respectively. The first light-emitting structure 10 and the second light-emitting structure 20 may emit, for example, green light and blue light, respectively.

The light-emitting unit 100 may be formed by sequentially stacking the first light-emitting structure 10, the second light-emitting structure 20, and the third light-emitting structure 30. In the present embodiment, the side surface 103 of the light-emitting unit 100 may be parallel to the stacking direction of the first light-emitting structure 10, the second light-emitting structure 20, and the third light-emitting structure 30. Here, "parallel" does not exclusively mean being perfectly parallel to the stacking direction, but also encompasses a natural inclination that occurs during a process of mesa-etching the light-emitting unit 100.

The common electrode 40 may be an electrode common to the first light-emitting structure 10, the second light-emitting structure 20, and the third light-emitting structure 30. The common electrode 40 may be electrically connected to the first conductivity-type semiconductor layers 11, 21, and 31 or the second conductivity-type semiconductor layers 13, 23, and 33 of the first light-emitting structure 10, the second light-emitting structure 20, and the third light-emitting structure 30. In the present embodiment, the common electrode 40 may be electrically connected to the second conductivity-type semiconductor layers 13, 23, and 33 of the first light-emitting structure 10, the second light-emitting structure 20, and the third light-emitting structure 30. In the present embodiment, because the second conductivity-type semiconductor layers 13, 23, and 33 may be p-type semiconductor layers, the common electrode 40 may be referred to as a p-type common electrode. The common electrode 40 may be provided on the side surface 103 of the light-emitting unit 100. The side surface 103 of the light-emitting unit 100 may be a surface connecting an upper surface 101 of the light-emitting unit 100 to the lower surface 102. The common electrode 40 may be in contact with side surfaces 13s, 23s, and 33s of the second conductivity-type semiconductor layers 13, 23, and 33 of the first light-emitting structure 10, the second light-emitting structure 20, and the third light-emitting structure 30. The common electrode 40 may extend along the side surface 103 of the light-emitting unit 100 in the direction in which the first light-emitting structure 10, the second light-emitting structure 20, and the third light-emitting structure 30 are stacked, and may extend entirely or partially in the circumferential direction. In other words, the common electrode 40 may entirely surround the side surface 103 of the light-emitting unit 100, or may partially surround the side surface 103 of the light-emitting unit 100. The common electrode 40 may extend on to the upper surface 101 of the light-emitting unit 100, that is, for example, to the upper surface of the second conductivity-type semiconductor layer 33 of the third light-emitting structure 30. The common electrode 40 may cover the entire upper surface 101 of the light-emitting unit 100, that is, for example, the upper surface of the second conductivity-type semiconductor layer 33 of the third light-emitting structure 30. The common electrode 40 may include an electrode material. The electrode material may include, for example, Al, Ti, Pt, Ag, Au, Pd, TiW, or various combinations thereof. The common electrode 40 may include a transparent electrode material. The transparent electrode material may include, for example, ITO.

The insulating layers 60 may insulate, from the common electrode 40, side surfaces 11s, 21s, and 31s of the first conductivity-type semiconductor layers 11, 21, and 31, and side surfaces 12s, 22s, and 32s of the active layers 12, 22, and 32 of the first light-emitting structure 10, the second light-emitting structure 20, and the third light-emitting structure 30, respectively. The insulating layers 60 may include a first insulating layer 61, a second insulating layer 62, and a third insulating layer 63. The first insulating layer 61 may be arranged between the common electrode 40 and the side surfaces 11s and 12s of the first conductivity-type semiconductor layer 11 and the active layer 12 of the first light-emitting structure 10. The second insulating layer 62 may be arranged between the common electrode 40 and the side surfaces 21s and 22s of the first conductivity-type semiconductor layer 21 and the active layer 22 of the second light-emitting structure 20. The third insulating layer 63 may be arranged between the common electrode 40 and the side surfaces 31s and 32s of the first conductivity-type semiconductor layer 31 and the active layer 32 of the third light-emitting structure 30. The material of the insulating layer 60 is not particularly limited. For example, the insulating layer 60 may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. The thickness of the insulating layer 60 may be 5 nm to 50 nm.

In an embodiment, the side surfaces 11s, 21s, and 31s of the first conductivity-type semiconductor layers 11, 21, and 31, and the side surfaces 12s, 22s, and 32s of the active layers 12, 22, and 32 of the first light-emitting structure 10, the second light-emitting structure 20, and the third light-emitting structure 30 may be concavely stepped inward from the side surfaces 13s, 23s, and 33s of the second conductivity-type semiconductor layers 13, 23, and 33 of the first light-emitting structure 10, the second light-emitting structure 20, and the third light-emitting structure 30. As a result, recessed portions 50 including a first recessed portion 51, a second recessed portion 52, and a third recessed portion 53, which may be concavely stepped inward, may be formed in the side surface 103 of the light-emitting unit 100. A step length 50S of the recessed portions 50, in other words, a step length of the side surfaces 11s, 21s, and 31s of the first conductivity-type semiconductor layers 11, 21, and 31, and the side surfaces 12s, 22s, and 32s of the active layers 12, 22, and 32 of the first light-emitting structure 10, the second light-emitting structure 20, and the third light-emitting structure 30, with respect to the side surfaces 13s, 23s, and 33s of the second conductivity-type semiconductor layers 13, 23, and 33 of the first light-emitting structure 10, the second light-emitting structure 20, and the third light-emitting structure 30, may be 0.5 µm or less.

The insulating layers 60 may be provided in the recessed portions 50. In other words, the first insulating layer 61, the second insulating layer 62, and the third insulating layer 63 may be provided in the first recessed portion 51, the second recessed portion 52, and the third recessed portion 53, respectively. The side surfaces 11s and 12s of the first conductivity-type semiconductor layer **11** and the active layer 12, and a portion of the lower surface of the second conductivity-type semiconductor layer 13, which may be included in the first light-emitting structure 10, may be exposed by the first recessed portion 51. The first insulating layer 61 may cover the side surfaces 11s and 12s of the first conductive-type semiconductor layer **11** and the active layer 12, and the exposed portion of the lower surface of the second conductivity-type semiconductor layer 13, which may be included in the first light-emitting structure 10. A portion of the upper surface of the second conductivity-type semiconductor layer 13 of the first light-emitting structure 10, and the side surfaces 21s and 22s of the first conductivity-type semiconductor layer 21 and the active layer 22, and a portion of the lower surface of the second conductivity-type semiconductor layer 23, which may be included in the second light-emitting structure 20, may be exposed by the second recessed portion 52. The second insulating layer 62 may cover the exposed portion of the upper surface of the second conductivity-type semiconductor layer 13 of the first light-emitting structure 10, and the side surfaces 21s and 22s of the first conductivity-type semiconductor layer 21 and the active layer 22, and the exposed portion of the lower surface of the second conductivity-type semiconductor layer 23, which may be included in the second light-emitting structure 20. A portion of the upper surface of the second conductivity-type semiconductor layer 23 of the second light-emitting structure 20, and the side surfaces 31s and 32s of the first conductivity-type semiconductor layer 31 and the active layer 32, and a portion of the lower surface of the second conductivity-type semiconductor layer 33, which may be included in the third light-emitting structure 30, may be exposed by the third recessed portion 53. The third insulating layer 63 may cover the exposed portion of the upper surface of the second conductivity-type semiconductor layer 23 of the second light-emitting structure 20, and the side surfaces 31s and 32s of the first conductivity-type semiconductor layer 31 and the active layer 32, and the exposed portion of the lower surface of the second conductivity-type semiconductor layer 33, which may be included in the third light-emitting structure 30.

The plurality of individual electrodes may be provided on the lower surface 102 of the light-emitting unit 100. In the present embodiment, the plurality of individual electrodes may include a first individual electrode 71, a second individual electrode 72, and a third individual electrode 73. The first individual electrode 71, the second individual electrode 72, and the third individual electrode 73 may be in contact with the first conductivity-type semiconductor layers 11, 21, and 31 of the first light-emitting structure 10, the second light-emitting structure 20, and the third light-emitting structure 30, respectively. That the plurality of individual electrodes are provided on the lower surface 102 of the light-emitting unit 100 means that the plurality of individual electrodes are provided on the lower side rather than the upper side in the stacking direction of the plurality of light-emitting structures 10, 20, and 30 of the light-emitting unit 100. With respect to the first individual electrode 71, the lower surface 102 of the light-emitting unit 100 may refer to the lower surface of the first conductivity-type semiconductor layer **11** of the first light-emitting structure 10, and with respect to the second individual electrodes 72 and the third individual electrode 73, the lower surface 102 of the light-emitting unit 100 may refer to the lower surface of a passivation layer 74 provided on the lower surface of the first conductivity-type semiconductor layer 11 of the first light-emitting structure 10.

The first individual electrode 71 may be provided on the lower surface 102 of the light-emitting unit 100. The first individual electrode 71 may include a first electrode pad 71a that is in contact with the lower surface of the first conductivity-type semiconductor layer **11** of the first light-emitting structure 10, which may form the lower surface 102 of the light-emitting unit 100. The second individual electrodes 72 and the third individual electrode 73 may have conductive via structures. The second individual electrode 72 may include a second electrode pad 72a that is arranged on the lower surface 102 of the light-emitting unit 100 so as to be insulated from the lower surface of the first conductivity-type semiconductor layer 11 of the first light-emitting structure 10, and a second conductive via 72b that electrically connects the second electrode pad 72a to the first conductivity-type semiconductor layer 21 of the second light-emitting structure 20. That is, the second individual electrode 72 may penetrate the first light-emitting structure 10 to be in contact with the first conductivity-type semiconductor layer 21 of the second light-emitting structure 20. A passivation layer 72c may insulate the second conductive via 72b from the first light-emitting structure 10. The third individual electrode 73 may include a third electrode pad 73a that is arranged on the lower surface 102 of the light-emitting unit 100 so as to be insulated from the lower surface of the first conductivity-type semiconductor layer 11 of the first light-emitting structure 10, and a third conductive via 73b that electrically connects the third electrode pad 73a to the first conductivity-type semiconductor layer 31 of the third light-emitting structure 30. That is, the third individual electrode 73 may penetrate the first light-emitting structure 10 and the second light-emitting structure 20 to be in contact with the first conductivity-type semiconductor layer 31 of the third light-emitting structure 30. A passivation layer 73c may insulate the third conductive via 73b from the first light-emitting structure 10 and the second light-emitting structure 20. The second individual electrode 72 and the third individual electrode 73 may be electrically insulated from the first conductivity-type semiconductor layer 11 of the first light-emitting structure 10. For example, the passivation layer 74 may be arranged between the second electrode pad 72a and the lower surface of the first conductivity-type semiconductor layer 11 of the first light-emitting structure 10, and between the third electrode pad 73a and the lower surface of the first conductivity-type semiconductor layer 11 of the first light-emitting structure 10.

The light-emitting device 1 may be bonded to a substrate 200 of a display panel. The substrate 200 of the display panel may include bonding pads 201, 202, and 203 corresponding to the first individual electrode 71, the second individual electrode 72, and the third individual electrode 73, respectively. According to some embodiments, a bonding pad corresponding to the common electrode 40 may be provided in the substrate 200 of the display panel. FIG. 1 illustrates that the substrate 200 of the display panel is separated from the light-emitting device 1.

In a vertical light-emitting device in which three light-emitting structures are stacked, six electrodes may be required to drive the respective light-emitting structures, and in a case in which electrodes are individually formed for the respective light-emitting structures, five of the electrodes may have conductive via structures. In a case in which, in a vertical light-emitting device, five electrodes may have conductive via structures, the light emission area of each light-emitting structure may decrease by the area occupied by the conductive vias, which may lower the light emission efficiency. According to an embodiment of the present disclosure, p-type electrodes or n-type electrodes of a plurality of light-emitting structures such as, for example, the p-type electrodes, may be formed as a single common electrode, and the other of the p-type electrodes and the n-type electrodes such as, for example, the n-type electrodes, may be formed as individual electrodes. The common electrode may be formed on a side surface of a light-emitting unit in which the light-emitting structures are stacked. As a result, the size of the light-emitting device 1, in other words, the pixel size, may be maximized. In addition, the number of conductive via structures may be reduced to, for example, two, which may increase the light emission area, thus increasing the light emission efficiency, and reducing the power consumption.

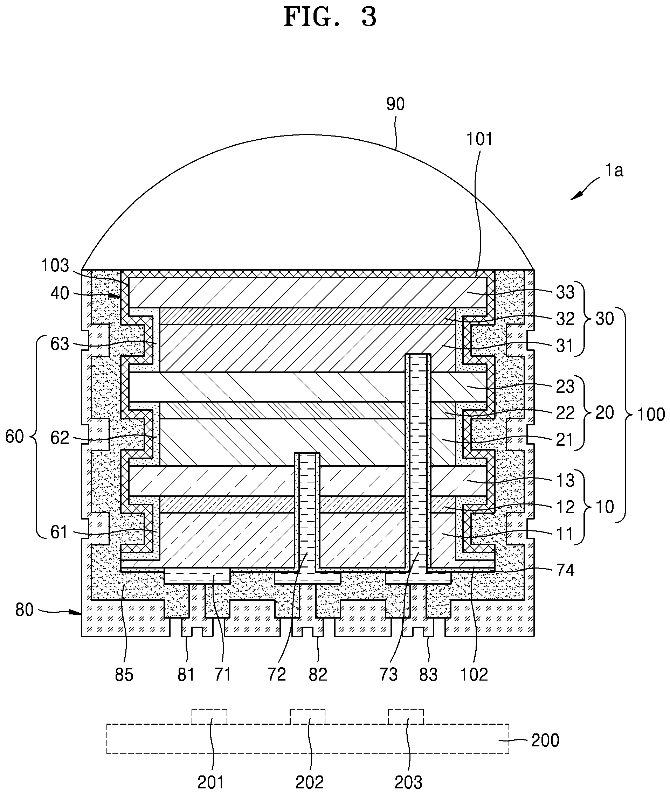

FIG. 3 is a schematic cross-sectional view of a light-emitting device 1a according to an embodiment. The light-emitting device 1a of the present embodiment differs from the light-emitting device 1 illustrated in FIG. 1 in that the light-emitting device 1a further includes a reflective layer 80 and a lens 90. In the following description, the focus will be on the differences between the light-emitting device 1 and the light-emitting device 1a, components having the same function will be indicated by the same reference numeral, and redundant descriptions may be omitted.

Referring to FIG. 3, the light-emitting device 1a may further include the reflective layer 80. The reflective layer 80 may surround the side surface 103 of the light-emitting unit 100. The reflective layer 80 may surround the surfaces (e.g., the lower surface 102 and the side surface 103) of the light-emitting unit 100 other than the upper surface 101. In this case, the common electrode 40 may include a transparent electrode material such as, for example, ITO. The reflective layer 80 may reflect light generated from the first light-emitting structure 10, the second light-emitting structure 20, and the third light-emitting structure 30 to be emitted toward the upper surface 101 of the light-emitting unit 100. As a result, the light emission efficiency of the light-emitting device 1a may be improved. The reflective layer 80 may be formed of a material having reflectivity. Along with the reflective layer 80, connection pads 81, 82, and 83 may be formed to electrically connect the first individual electrode 71, the second individual electrode 72, and the third individual electrode 73 to the substrate 200 of the display panel. The connection pads 81, 82, and 83 may be in contact with the first individual electrode 71, the second individual electrode 72, and the third individual electrode 73, respectively, and may be electrically disconnected (e.g., electrically insulated) from the reflective layer 80. In this case, the reflective layer 80 may be formed of a conductive material having reflectivity. For example, the conductive material may include Al, Ti, Pt, Ag, Au, Pd, TiW, or various combinations thereof. For insulation between the common electrode 40 and the reflective layer 80, a passivation layer 85 may be arranged between the common electrode 40 and the reflective layer 80. The connection pads 81, 82, and 83 may be electrically insulated from the reflective layer 80 by the passivation layer 85. The passivation layer 85 may include a light-transmissive insulating material. For example, the light-transmissive insulating material may include SiO₂.

Referring to FIG. 3, the light-emitting device 1a may further include the lens 90. The lens 90 may be provided on the upper surface 101 of the light-emitting unit 100. The lens 90 may be formed by, for example, thermal forming of photoresist. The lens 90 may adjust an emission angle of light generated from the first light-emitting structure 10, the second light-emitting structure 20, and the third light-emitting structure 30 and then emitted through the upper surface 101 of the light-emitting unit 100. As a result, light may be emitted from the light-emitting device 1a within a desired angular range.

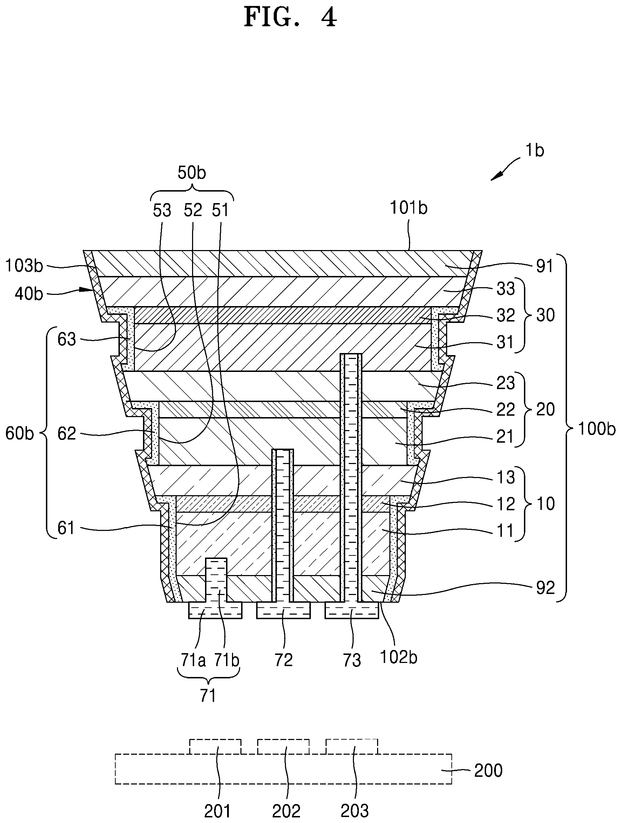

In the above-described embodiments, the side surface 103 of the light-emitting unit 100 may be parallel to the stacking direction of the first light-emitting structure 10, the second light-emitting structure 20, and the third light-emitting structure 30, but embodiments of the present disclosure are not limited thereto. The side surface of the light-emitting unit may have a certain angle of inclination. FIG. 4 is a schematic cross-sectional view of a light-emitting device 1b according to an embodiment. In the following description, the focus will be on the differences between the above-described light-emitting device 1 and the light-emitting device 1a, components having the same function will be indicated by the same reference numeral, and redundant descriptions may be omitted.

Referring to FIG. 4, the light-emitting device 1b of the present embodiment may include a light-emitting unit 100b. The light-emitting unit 100b may differ from the light-emitting unit 100 illustrated in FIGS. 1 to 3 in that the light-emitting unit 100b may have an inclined side surface 103b to expand outward from the first light-emitting structure 10 toward the third light-emitting structure 30. The description of the light-emitting unit 100 may apply to the light-emitting unit 100b. The light-emitting unit 100b may include the first light-emitting structure 10, the second light-emitting structure 20, the third light-emitting structure 30, and light-transmissive insulating layers 91 and 92. A common electrode 40b may be provided on the inclined side surface 103b of the light-emitting unit 100b. In the present embodiment, the common electrode 40b may be provided on the inclined side surface 103b of the light-emitting unit 100b and may not extend on to an upper surface 101b. The description of the common electrode 40 illustrated in FIGS. 1 to 3 may apply to the common electrode 40b. The side surfaces of the first conductivity-type semiconductor layers 11, 21, and 31 and the active layers 12, 22, and 32 of the first light-emitting structure 10, the second light-emitting structure 20, and the third light-emitting structure 30 may be insulated from the common electrode 40b by insulating layers 60b. The description of the insulating layers 60 illustrated in FIGS. 1 to 3 may apply to the insulating layers 60b. The insulating layers 60b may be provided in recessed portions 50b provided in the side surface 103b of the light-emitting unit 100b. The description of the recessed portions 50 may apply to the recessed portions 50b. The light-transmissive insulating layer 91 may be provided on the upper surface of the third light-emitting structure 30. The light-transmissive insulating layer 91 may include, for example, SiO₂ or SiN. The light-transmissive insulating layer 92 may be provided on the lower surface of the first light-emitting structure 10. The light-transmissive insulating layer 92 may include, for example, SiO₂ or SiN. Thus, the upper surface 101b of the light-emitting unit 100b may be the upper surface of the light-transmissive insulating layer 91, and a lower surface 102b of the light-emitting unit 100b may be the lower surface of the light-transmissive insulating layer 92.

In a case in which the light-emitting unit 100b having the side surface 103b that expands toward the third light-emitting structure 30 as described above is employed, light generated from the first light-emitting structure 10, the second light-emitting structure 20, and the third light-emitting structure 30 may be directed toward the upper surface 101b of the light-emitting unit 100b, which is the light emission side, and thus, the light extraction efficiency may be improved.

The light-emitting device 1b of the present embodiment may include the first individual electrode 71, the second individual electrode 72, and the third individual electrode 73. The first individual electrode 71, the second individual electrode 72, and the third individual electrode 73 may be provided on the lower surface 102b of the light-emitting unit 100b, that is, on the lower surface of the light-transmissive insulating layer 92. The first individual electrode 71, the second individual electrode 72, and the third individual electrode 73 may all have conductive via structures. The first individual electrode 71 may include the first electrode pad 71a provided on the lower surface 102b of the light-emitting unit 100b, and a first conductive via 71b that electrically connects the first electrode pad 71a to the first conductivity-type semiconductor layer 11 of the first light-emitting structure 10. The first conductive via 71b may penetrate the light-transmissive insulating layer 92 and extend into the first conductivity-type semiconductor layer 11. Likewise, the second individual electrodes 72 and the third individual electrode 73 may include the second electrode pad 72a and the third electrode pad 73a provided on the lower surface 102b of the light-emitting unit 100b, and the second conductive via 72b and the third conductive via 73b that electrically connect the second electrode pad 72a and the third electrode pad 73a to the first conductivity-type semiconductor layers 21 and 31 of the second light-emitting structure 20 and third light-emitting structure 30, respectively. The second conductive via 72b may penetrate the light-transmissive insulating layer 92 and the first light-emitting structure 10 and extend into the first conductivity-type semiconductor layer 21 of the second light-emitting structure 20. The third conductive via 73b may penetrate the light-transmissive insulating layer 92, the first light-emitting structure 10, and the second light-emitting structure 20, and may extend into the first conductivity-type semiconductor layer 31 of the third light-emitting structure 30.

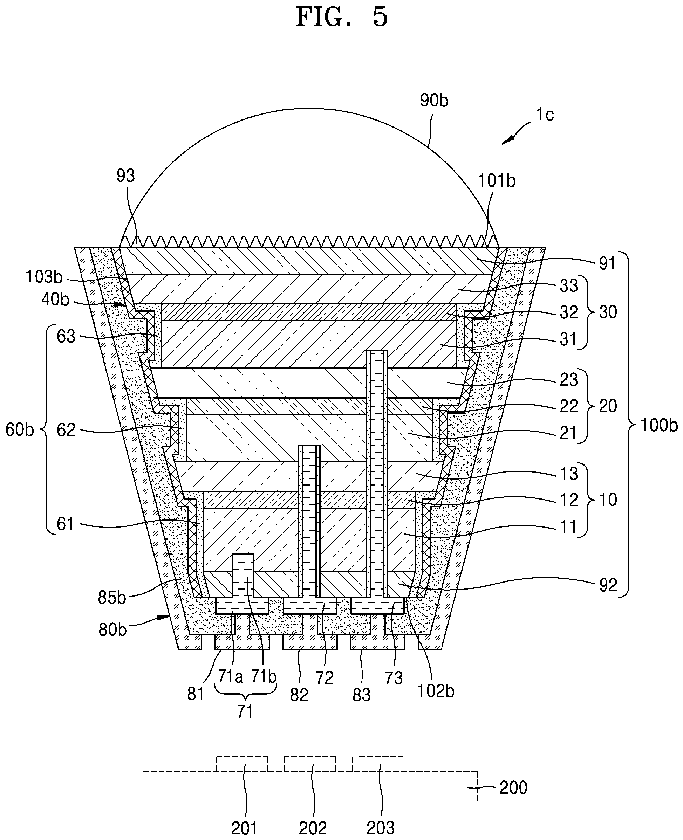

FIG. 5 is a schematic cross-sectional view of a light-emitting device 1c according to an embodiment. The light-emitting device 1c of the present embodiment may differ from the light-emitting device 1b illustrated in FIG. 4 in that the light-emitting device 1c may further include a reflective layer 80b, a scattering pattern 93, and a lens 90b. In the following description, the focus will be on the differences between the light-emitting device 1b and the light-emitting device 1c, components having the same function will be indicated by the same reference numeral, and redundant descriptions may be omitted.

Referring to FIG. 5, the reflective layer 80b may surround the side surface 103b of the light-emitting unit 100b. The description of the reflective layer 80 of FIGS. 1 to 3 may apply to the reflective layer 80b. A passivation layer 85b may insulate the common electrode 40b from the reflective layer 80b. The description of the passivation layer 85 of FIGS. 1 to 3 may apply to the passivation layer 85b.

The scattering pattern 93 may be provided on the upper surface 101b of the light-emitting unit 100b, that is, on the light-transmissive insulating layer 91. The lens 90b may be provided on the scattering pattern 93. Of light emitted from the active layers 12, 22, and 32 of the first light-emitting structure 10, the second light-emitting structure 20, and the third light-emitting structure 30, light having an incident angle with respect to the light-transmissive insulating layer 91 smaller than a critical angle may pass through the light-transmissive insulating layer 91 and may then be emitted to the outside, and the remaining light may be totally reflected into the light-emitting unit 100b. As such, in a comparative embodiment, light trapped inside the light-emitting device 1c by total internal reflection may be a factor that reduces the light extraction efficiency of the light-emitting device 1c. The scattering pattern 93 may be, for example, a concave-convex pattern for scattering light. When light emitted from the active layers 12, 22, and 32 of the first light-emitting structure 10, the second light-emitting structure 20, and the third light-emitting structure 30 is incident on the scattering pattern 93, the light is scattered by the scattering pattern 93. Accordingly, the light emitted from the light-emitting device 1c may have a uniform light intensity distribution. In addition, when light trapped inside the light-emitting device 1c by total internal reflection is incident on the scattering pattern 93, the light is scattered, thus changing its direction of propagation. As such, the scattering pattern 93 may scatter the light, which is trapped inside the light-emitting device 1c by total internal reflection, to change the direction of propagation of the light, causing the light to be emitted from the light-emitting device 1c. With this configuration, it is possible to implement the light-emitting device 1c with improved light extraction efficiency. According to some embodiments, the scattering pattern 93 may also be applied to the light-emitting device 1 and the light-emitting device 1a illustrated in FIGS. 1 to 3. For example, according to some embodiments, the scattering pattern may be provided on the upper surface 101 of the light-emitting unit 100 in the light-emitting device 1a illustrated in FIG. 3, and the lens 90 may be provided on the scattering pattern.

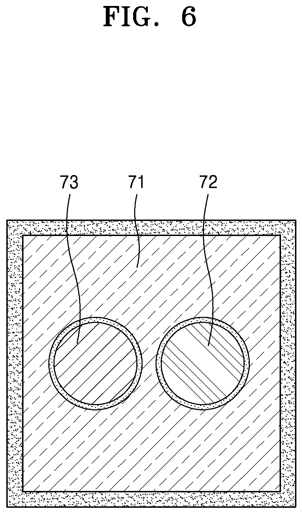

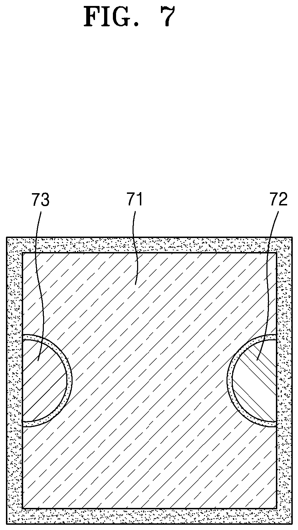

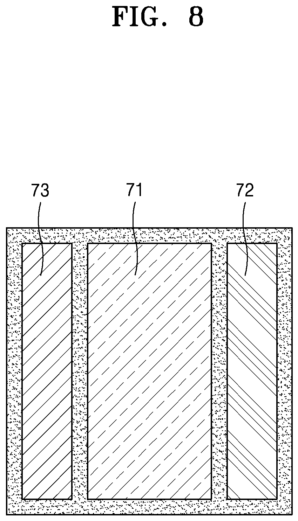

The planar arrangement of the first individual electrode 71, the second individual electrode 72, and the third individual electrode 73 is not particularly limited. FIGS. 6, 7, and 8 illustrate examples of the planar arrangement of the first individual electrode 71, the second individual electrode 72, and the third individual electrode 73. For example, referring to FIG. 6, the second individual electrode 72 and the third individual electrode 73 may be spaced apart from each other inside the first individual electrode 71, which may have a quadrangular shape. Referring to FIG. 7, the second individual electrode 72 and the third individual electrode 73 may be arranged adjacent to two edges of the first individual electrode 71, which may have a quadrangular shape, and the two edges may be spaced apart from each other. Referring to FIG. 8, the first individual electrode 71, the second individual electrode 72, and the third individual electrode 73 may each have a rectangular shape, and the first individual electrode 71, the second individual electrode 72, and the third individual electrode 73 may be arranged in a transverse or longitudinal direction with respect to each other.

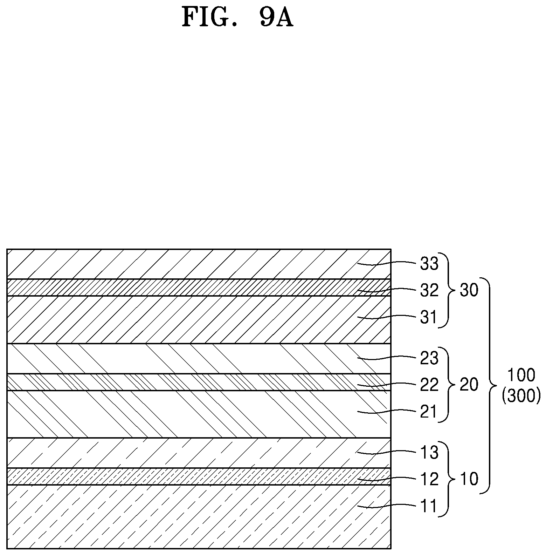

Hereinafter, examples of a method of manufacturing the light-emitting devices will be described. FIGS. 9A to 9M illustrate an example of a method of manufacturing the light-emitting devices 1 and 1a illustrated in FIGS. 1 and 3.

First, a process of forming the light-emitting unit 100 may be performed. Referring to FIG. 9A, the first light-emitting structure 10, the second light-emitting structure 20, and the third light-emitting structure 30 may be sequentially stacked and grown on a growth substrate. The growth substrate may be for semiconductor single crystal growth, and for example, a silicon (Si) substrate, a silicon carbide (SiC) substrate, a sapphire substrate, etc., may be used as the growth substrate. In addition, a substrate made of a material suitable for the growth of light-emitting structures to be formed on the growth substrate, for example, AlN, AlGaN, ZnO, GaAs, MgAl₂O₄, MgO, LiAlO₂, LiGaO₂, or GaN, may be used. According to some embodiments, a buffer layer for epitaxial growth of a light-emitting structure may be provided on a surface of the growth substrate, and the light-emitting structure may be grown on the buffer layer.

For example, the first light-emitting structure 10 may be formed by sequentially growing, on the growth substrate, the first conductivity-type semiconductor layer 11, the active layer 12, and the second conductivity-type semiconductor layer 13. The first light-emitting structure 10 may be formed of a group III-V nitride semiconductor material. The group III-V nitride semiconductor material may include, for example, GaN, InGaN, AlInGaN, AlGaInP, etc. In the present embodiment, the first light-emitting structure 10 may be formed of a GaN-based semiconductor material. The first conductivity-type semiconductor layer **11** may be, for example, an n-GaN layer doped with n-type impurities. As n-type impurities, Si, Ge, Se, Te, etc., may be used. The active layer 12 may be a layer that emits light by electron-hole recombination, and may have a single-quantum well or multi-quantum well structure as described above. For example, a quantum well layer and a barrier layer may be paired in the form of InGaN/GaN, InGaN/InGaN, InGaN/AlGaN, or InGaN/InAlGaN to form a quantum well structure, and the band gap energy may be controlled according to the composition ratio of indium (In) in a material layer including indium (In), such that the light emission wavelength range is adjusted. The second conductivity-type semiconductor layer 13 may be a p-GaN layer doped with p-type impurities. As p-type impurities, Mg, Zn, Be, etc., may be used. The description of the first light-emitting structure 10 may be applied to the second light-emitting structure 20 and the third light-emitting structure 30. The first light-emitting structure 10, the second light-emitting structure 20, and the third light-emitting structure 30 may be formed by hydride vapor-phase epitaxy (HVPE), molecular-beam epitaxy (MBE), metal-organic vapor-phase epitaxy (MOVPE), metal-organic chemical vapor deposition (MOCVD), other known methods, or a combination thereof. As a result, an epi-structure 300 including the light-emitting unit 100 may be formed.

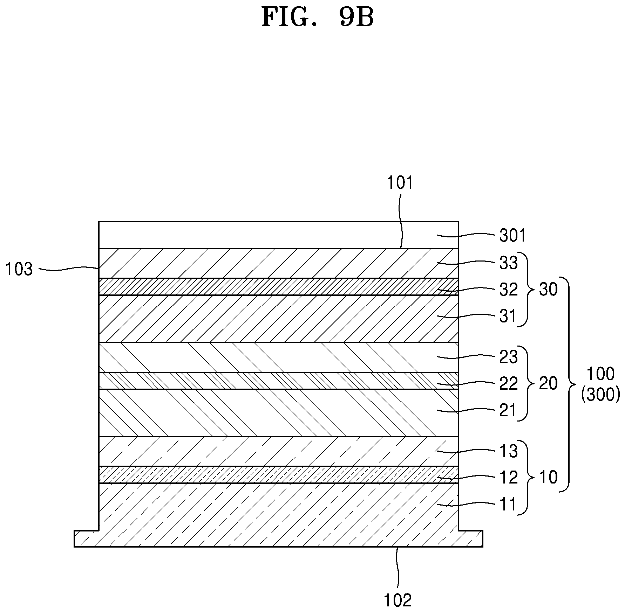

Referring to FIG. 9B, a mask layer 301 may be formed on the upper surface of the third light-emitting structure 30, and the epi-structure 300 may be mesa-etched. The mask layer 301 may be, for example, a SiN layer. The etching may be performed through a dry etching process or a wet etching process. The dry etching process may utilize, for example, inductively coupled plasma (ICP). The wet etching process may be performed by using, for example, a potassium hydroxide (KOH) solution or a tetramethylammonium hydroxide (TMAH) solution as an etchant.

Next, a process of forming the recessed portions 50 may be performed. To this end, a side surface of the epi-structure 300, that is, the side surface 103 of the light-emitting unit 100, may be etched. The etching may be performed by using an OH-based etchant, such as a potassium hydroxide (KOH) solution or a tetramethylammonium hydroxide (TMAH) solution. The etch rates of these etchants for GaN-based materials may depend on whether the GaN-based material is doped and the type of dopant. For example, the etch rates of these etchants for n-GaN may be significantly higher than their etch rates for p-GaN. In fact, these etchants may etch n-GaN at a significantly high rate, but etch p-GaN at a negligibly low rate. As such, the first conductivity-type semiconductor, which may be an n-GaN layer, and the undoped active layer may be selectively etched by utilizing the difference in etching rates depending on the dopant. The upper surface 101 of the light-emitting unit 100 may be protected by the mask layer 301.

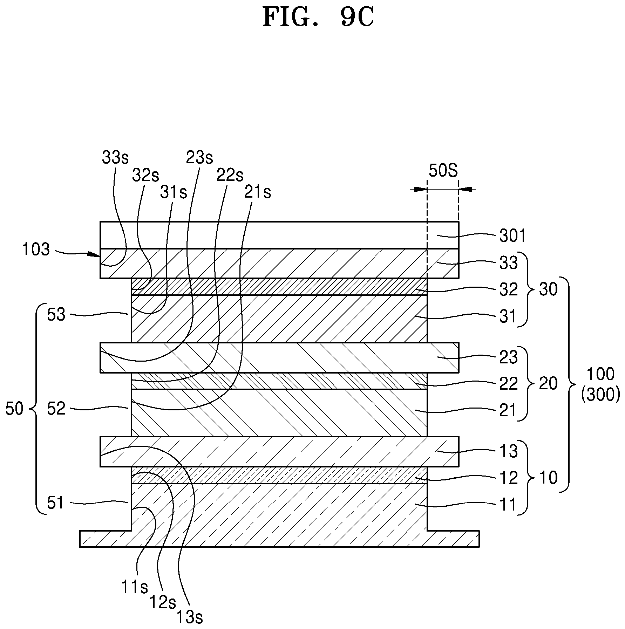

By this selective etching process, as illustrated in FIG. 9C, the side surfaces 11s and 12s of the first conductivity-type semiconductor layer 11 and the active layer 12 of the first light-emitting structure 10 may be stepped inward from the side surface 13s of the second conductivity-type semiconductor layer 13, such that the first recessed portion 51 is formed. Likewise, the side surfaces 21s and 22s of the first conductivity-type semiconductor layer 21 and the active layer 22 of the second light-emitting structure 20 may be stepped inward from the side surface 23s of the second conductivity-type semiconductor layer 23 to form the second recessed portion 52, and the side surfaces 31s and 32s of the first conductivity-type semiconductor layer 31 and the active layer 32 of the third light-emitting structure 30 may be stepped inward from the side surface 33s of the second conductivity-type semiconductor layer 33 to form the third recessed portion 53. The recessed portions 50 which may include the first recessed portion 51, the second recessed portion 52, and the third recessed portion 53 may be formed in the side surface 103 of the light-emitting unit 100. The step length 50S of the recessed portions 50 may be determined by the etching time. The etching time may be adjusted such that the step length 50S is 0.5 µm or less.

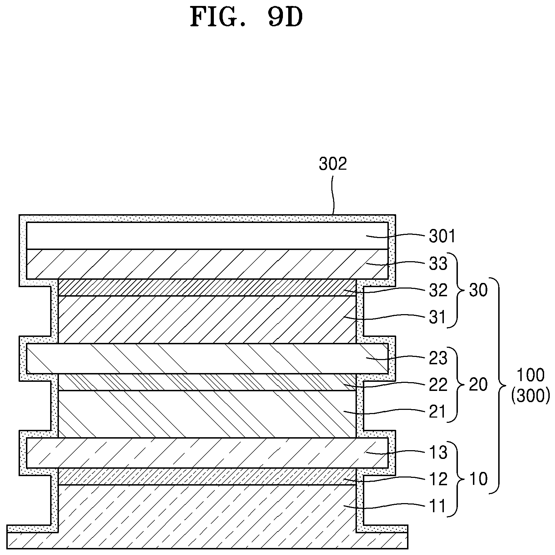

Next, the insulating layer 60 may be formed. Referring to FIG. 9D, an insulating material layer 302 may be formed. The insulating material layer 302 may be formed on the side surface 103 of the light-emitting unit 100 including the recessed portions 50, and on the upper surface of the mask layer 301. The insulating material is not particularly limited. For example, the insulating material may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. The thickness of the insulating material layer 302 may be 5 nm to 50 nm. In the present embodiment, the insulating material layer 302 may be formed of SiO₂, which is a light-transmissive insulating material. For example, the insulating material layer 302 may be formed by sputtering, atomic layer deposition (ALD), plasma-enhanced atomic layer deposition (PEALD), chemical vapor deposition (CVD), plasma-enhanced chemical vapor deposition (PECVD), physical vapor deposition (PVD), other known methods, or a combination thereof. In the present embodiment, the light-transmissive insulating material layer 302 may be formed by ALD.

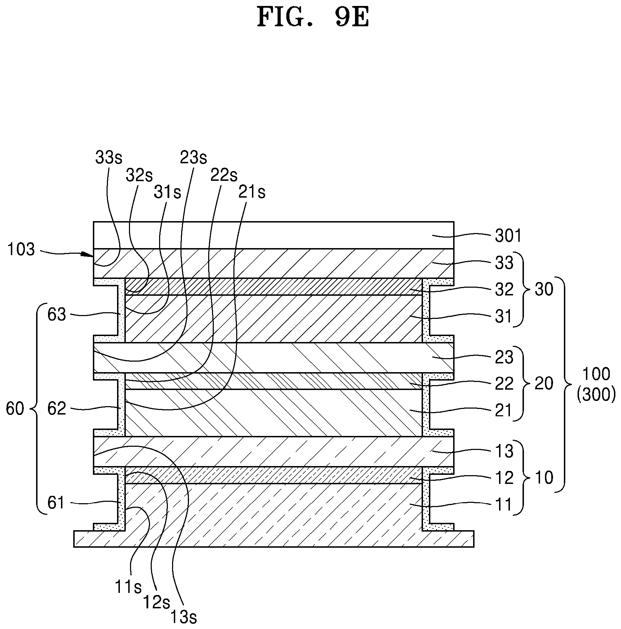

As illustrated in FIG. 9E, the insulating layers 60 including the first insulating layer 61, the second insulating layer 62, and the third insulating layer 63 may be formed by removing the light-transmissive insulating material layer 302 formed on the side surfaces 13s, 23s, and 33s of the second conductivity-type semiconductor layers 13, 23, and 33 of the first light-emitting structure 10, the second light-emitting structure 20, and the third light-emitting structure 30. This process may be performed by, for example, a dry etching process.

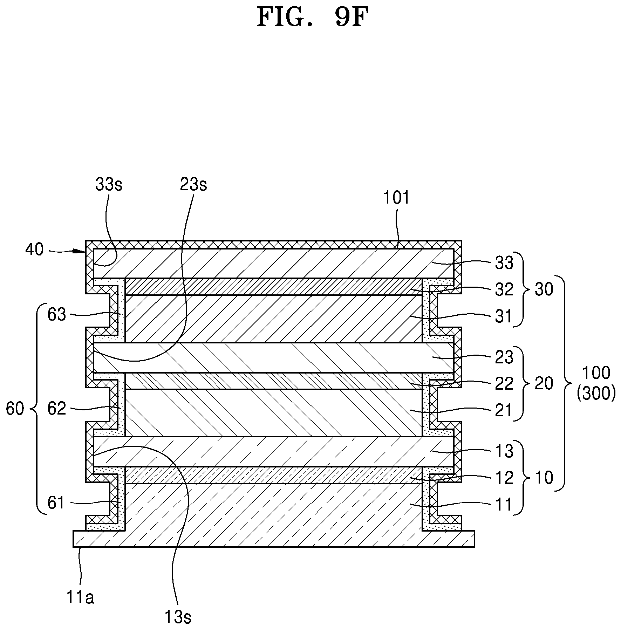

Next, a process of forming the common electrode 40 may be performed. First, the mask layer 301 may be removed to expose the upper surface 101 of the light-emitting unit 100. Then, an electrode material may be deposited on the upper surface 101 and the side surface 103 of the light-emitting unit 100. The electrode material may cover the side surfaces 13s, 23s, and 33s of the second conductivity-type semiconductor layers 13, 23, and 33 of the first light-emitting structure 10, the second light-emitting structure 20, and the third light-emitting structure 30, and the insulating layer 60, and may cover up to the exposed upper surface 101 of the light-emitting unit 100. As a result, as illustrated in FIG. 9F, the common electrode 40 may be formed in contact with the side surfaces 13s, 23s, and 33s of the second conductivity-type semiconductor layers 13, 23, and 33 of the first light-emitting structure 10, the second light-emitting structure 20, and the third light-emitting structure 30. The electrode material may include, for example, Al, Ti, Pt, Ag, Au, Pd, TiW, or various combinations thereof. The electrode material may include a transparent electrode material such as, for example, ITO. This process may be formed by, for example, sputtering, ALD, PEALD, CVD, PECVD, PVD, other known methods, or a combination thereof. In the present embodiment, the common electrode 40 may be formed by ALD.

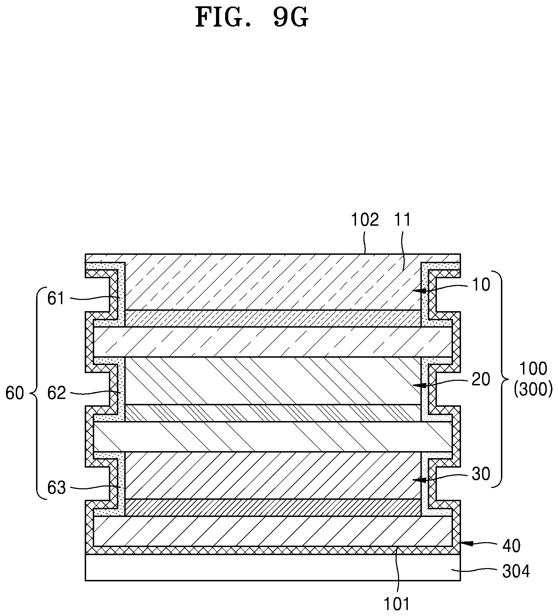

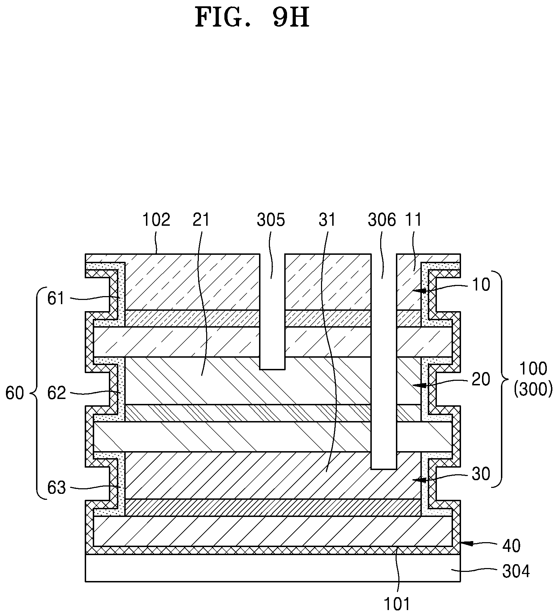

Next, a process of forming the first individual electrode 71, the second individual electrode 72, and the third individual electrode 73 will be described with reference to FIGS. 9G to 9J. As illustrated in FIG. 9G, a dummy substrate 304 may be attached on the common electrode 40 formed on the upper surface 101 of the light-emitting unit 100, and then the light-emitting unit 100 may be flipped over. The lower surface 102 of the light-emitting unit 100 that is exposed upward, that is, the lower surface of the first conductivity-type semiconductor layer 11 of the first light-emitting structure 10, may be polished to be planarized. At the same time, the portion 11a (see FIG. 9F) protruding from the side surface of the common electrode 40 in the first conductivity-type semiconductor layer 11 of the first light-emitting structure 10 may be removed. As illustrated in FIG. 9H, via holes 305 and 306 extending downward from the lower surface 102 of the light-emitting unit 100 may be formed. The via holes 305 and 306 may be formed by an etching process. The via hole 305 may extend from the lower surface of the first conductivity-type semiconductor layer 11 of the first light-emitting structure 10, through the first light-emitting structure 10 to the first conductivity-type semiconductor layer 21 of the second light-emitting structure 20. The via hole 305 may partially extend into the first conductivity-type semiconductor layer 21 of the second light-emitting structure 20. The via hole 306 may extend from the lower surface of the first conductivity-type semiconductor layer 11 of the first light-emitting structure 10, through the first light-emitting structure 10 and the second light-emitting structure 20 to the first conductivity-type semiconductor layer 31 of the third light-emitting structure 30. The via hole 306 may partially extend into the first conductivity-type semiconductor layer 31 of the third light-emitting structure 30.

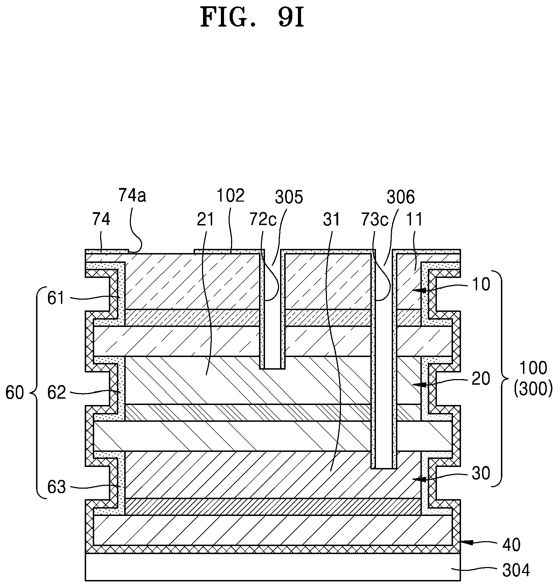

As illustrated in FIG. 9I, the passivation layer 74 and the passivation layers72c and 73c may be formed by depositing an insulating material on the lower surface 102 of the light-emitting unit 100, that is, the lower surface of the first conductivity-type semiconductor layer 11 of the first light-emitting structure 10, and on inner walls of the via holes 305 and 306. The insulating material is not particularly limited and may include, for example, SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. This process may be performed by, for example, sputtering, ALD, PEALD, CVD, PECVD, PVD, other known methods, or a combination thereof. An opening 74a may be formed in the passivation layer 74 to expose the lower surface of the first conductivity-type semiconductor layer 11 of the first light-emitting structure 10.

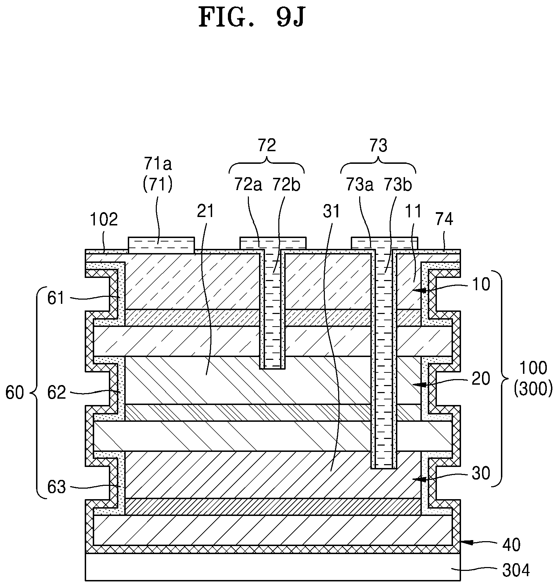

As illustrated in FIG. 9J, the first electrode pad 71a may be formed by depositing an electrode material on the lower surface 102 of the light-emitting unit 100, that is, the lower surface of the first conductivity-type semiconductor layer 11 of the first light-emitting structure 10, through the opening 74a of the passivation layer 74. As a result, the first individual electrode 71 may be formed. In addition, the second electrode pad 72a, the third electrode pad 73a, the second conductive via 72b, and the third conductive via 73b may be formed by depositing an electrode material on side walls of the via holes 305 and 306, and on the passivation layer 74. As a result, the second individual electrode 72 and the third individual electrode 73 may be formed.

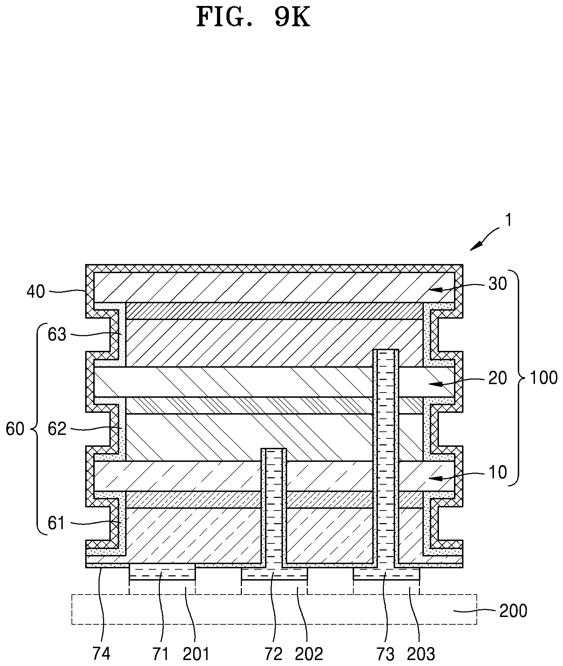

After completing the process illustrated in FIG. 9J, the light-emitting unit 100 may be flipped over and then bonded to the substrate 200 of the display panel provided with the bonding pads 201, 202, and 203 corresponding to the first individual electrode 71, the second individual electrode 72, and the third individual electrode 73, respectively, as illustrated in FIG. 9K. Then, the dummy substrate 304 may be removed. As a result, the light-emitting device 1 illustrated in FIG. 1 may be manufactured.

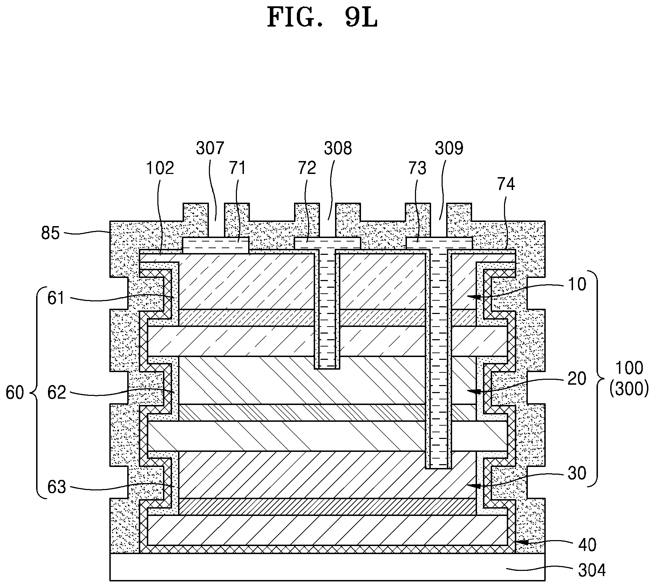

Next, a process of forming the reflective layer 80 and the passivation layer 85 will be described. After completing the process illustrated in FIG. 9J, the first individual electrode 71, the second individual electrode 72, and the third individual electrode 73 may be partially masked, and an insulating material may be deposited on the outer peripheral surface of the light-emitting unit 100. Then, when the mask is removed, the passivation layer 85 may be formed as illustrated in FIG. 9L. Contact holes 307, 308, and 309 may be formed in the passivation layer 85 to expose the first individual electrode 71, the second individual electrode 72, and the third individual electrode 73. The insulating material is not particularly limited and may include, for example, SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. This process may be performed by, for example, sputtering, ALD, PEALD, CVD, PECVD, PVD, other known methods, or a combination thereof. In the present embodiment, the passivation layer 85 may be formed by ALD.

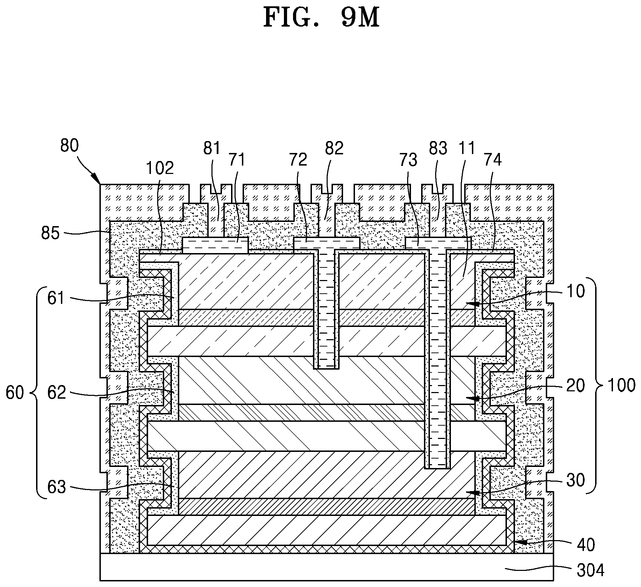

As illustrated in FIG. 9M, the reflective layer 80 may be formed by depositing a material having reflectivity such as, for example, a conductive material having reflectivity, on the outer periphery of the passivation layer 85. For example, the conductive material may include Al, Ti, Pt, Ag, Au, Pd, TiW, or various combinations thereof. The reflective layer 80 may be electrically isolated (e.g., electrically insulated) from the common electrode 40 by the passivation layer 85. The conductive material may fill the contact holes 307, 308, and 309. After depositing the conductive material, the conductive material layer may be patterned such that the conductive materials filled in the contact holes 307, 308, and 309 may be separated from each other. As a result, the connection pads 81, 82, and 83 for connecting the first individual electrode 71, the second individual electrode 72, and the third individual electrode 73 to the outside may be formed.

In the state illustrated in FIG. 9M, the light-emitting unit 100 may be flipped over and bonded to the substrate 200 of the display panel, and the dummy substrate 304 may be removed, as illustrated in FIG. 3. Then, the lens 90 may be formed on the upper surface 101 of the light-emitting unit 100 or on the surface of the common electrode 40 formed on the upper surface 101. The method of forming the lens 90 is not particularly limited. For example, a light-transmissive layer may be formed by depositing a thermoplastic material on the upper surface 101 of the light-emitting unit 100 or on the surface of the common electrode 40 formed on the upper surface 101. For example, the thermoplastic material may include photoresist, polyester, acryl, epoxy, etc. The shape of the light-transmissive layer may be, for example, a cylindrical shape. Then, for example, a thermal reflow process may be performed to shape the cylindrical light-transmissive layer into, for example, a dome-shaped lens. The curvature of the lens 90 may be controlled by the surface energy of the upper surface 101 of the light-emitting unit 100 or the surface of the common electrode 40 formed on the upper surface 101, the contact angle of the light-transmissive layer, the thickness and width of the light-transmissive layer, the thermal reflow process temperature, etc. As a result, the light-emitting device 1a illustrated in FIG. 3 may be manufactured.

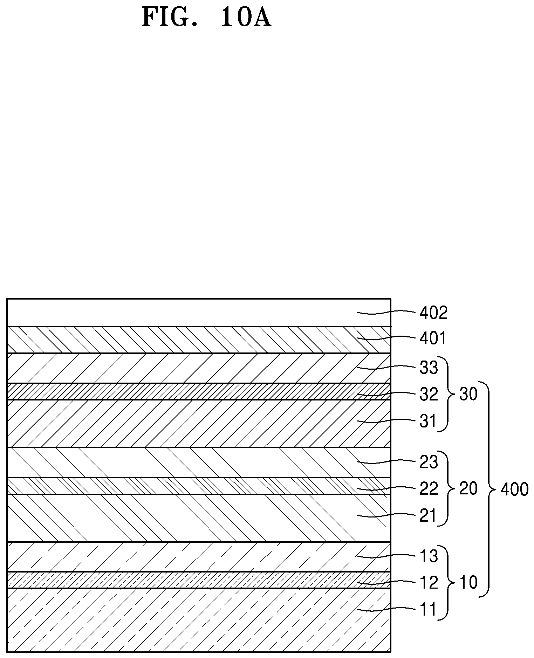

FIGS. 10A to 10L illustrate an example of a method of manufacturing the light-emitting devices 1b and 1c illustrated in FIGS. 4 and 5.

First, a process of forming the light-emitting unit 100b may be performed. Referring to FIG. 10A, the first light-emitting structure 10, the second light-emitting structure 20, and the third light-emitting structure 30 may be sequentially stacked and grown on a growth substrate. The process of sequentially growing the first light-emitting structure 10, the second light-emitting structure 20, and the third light-emitting structure 30 may be the same as described above with reference to FIG. 9A. As a result, an epi-structure 400 may be formed. Then, a light-transmissive insulating material may be deposited on the third light-emitting structure 30 to form a light-transmissive insulating layer 401, and a dummy substrate 402 is attached on the light-transmissive insulating layer 401. The light-transmissive insulating material may include, for example, SiO₂ or SiN. The light-transmissive insulating layer 401 may be formed by, for example, ALD. The dummy substrate 402 may be attached on the light-transmissive insulating layer 401.

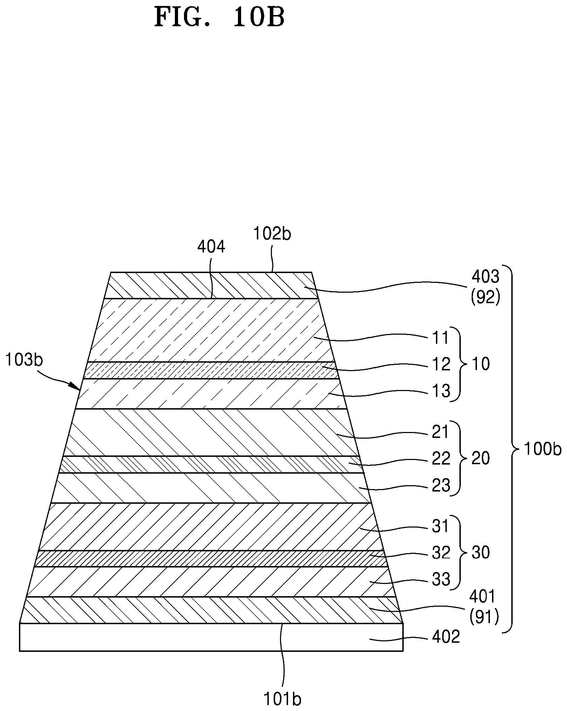

Next, as illustrated in FIG. 10B, the epi-structure 400 may be flipped over, and a light-transmissive insulating layer 403 may be formed by depositing a light-transmissive insulating material on a surface 404 of the epi-structure 400 that is exposed upward, that is, on the lower surface of the first conductivity-type semiconductor layer 11 of the first light-emitting structure 10. The light-transmissive insulating material may include, for example, SiO₂ or SiN. The light-transmissive insulating layer 403 may be formed by, for example, ALD. The epi-structure 400 may be mesa-etched by using the light-transmissive insulating layer 403 as a mask. The etching may be performed through a dry etching process or a wet etching process. The dry etching process may utilize, for example, ICP. The wet etching process may be performed by using, for example, a potassium hydroxide (KOH) solution or a tetramethylammonium hydroxide (TMAH) solution as an etchant. As a result, the light-emitting unit 100b including the first light-emitting structure 10, the second light-emitting structure 20, the third light-emitting structure 30, and the light-transmissive insulating layers 91 and 92, and having the inclined side surface 103b, may be formed.

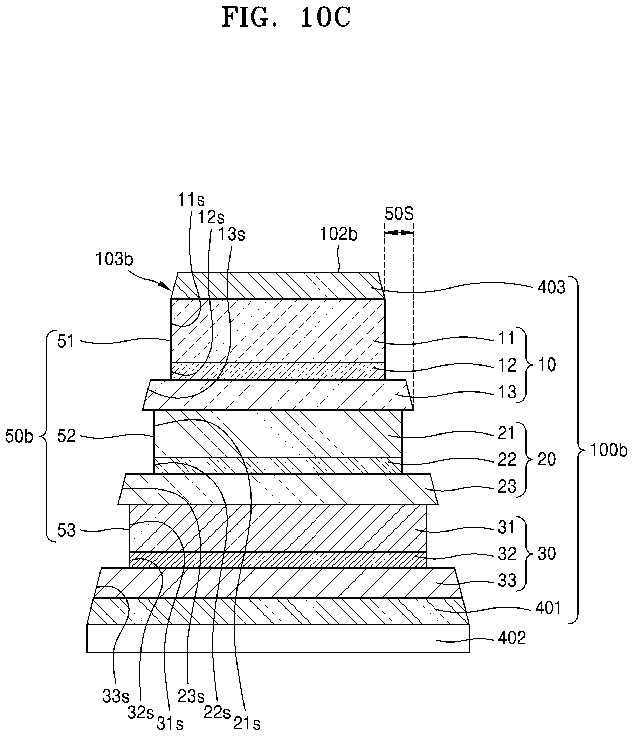

Next, a process of forming the recessed portions 50b may be performed. To this end, the side surface 103b of the light-emitting unit 100b may be etched. The etching may be performed by using an OH-based etchant, such as a potassium hydroxide (KOH) solution or a tetramethylammonium hydroxide (TMAH) solution. The etch rates of these etchants for GaN-based materials may depend on whether the GaN-based material is doped and the type of dopant. For example, the etch rates of these etchants for n-GaN may be significantly higher than their etch rates for p-GaN. In fact, these etchants may etch n-GaN at a significantly high rate, but etch p-GaN at a negligibly low rate. As such, the first conductivity-type semiconductor layer, which may be an n-GaN layer, and the undoped active layer may be selectively etched by utilizing the difference in etching rates depending on the dopant. By this selective etching process, as illustrated in FIG. 10C, the side surfaces 11s and 12s of the first conductivity-type semiconductor layer 11 and the active layer 12 of the first light-emitting structure 10 may be stepped inward from the side surface 13s of the second conductivity-type semiconductor layer 13, such that the first recessed portion 51 is formed. Likewise, the side surfaces 21s and 22s of the first conductivity-type semiconductor layer 21 and the active layer 22 of the second light-emitting structure 20 may be stepped inward from the side surface 23s of the second conductivity-type semiconductor layer 23 to form the second recessed portion 52, and the side surfaces 31s and 32s of the first conductivity-type semiconductor layer 31 and the active layer 32 of the third light-emitting structure 30 may be stepped inward from the side surface 33s of the second conductivity-type semiconductor layer 33 to form the third recessed portion 53. The recessed portions 50b including the first recessed portion 51, the second recessed portion 52, and the third recessed portion 53 may be formed in the side surface 103b of the light-emitting unit 100b. The step length 50S of the recessed portions 50b may be determined by the etching time. The etching time may be adjusted such that the step length 50S is 0.5 µm or less.

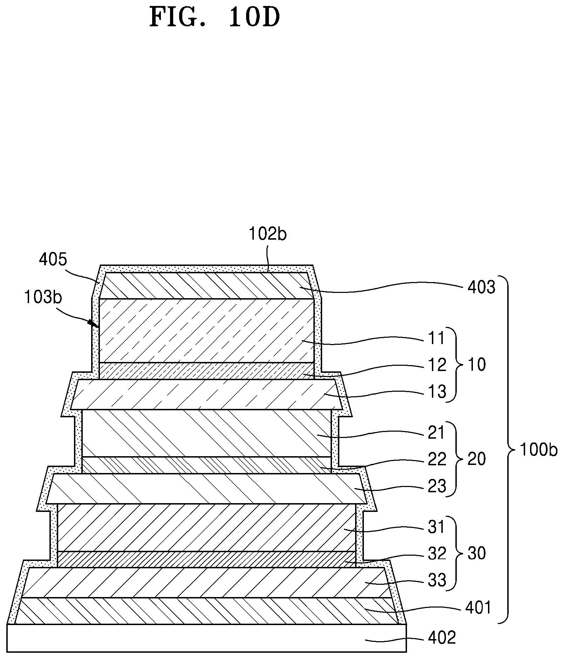

Next, the insulating layers 60b may be formed. Referring to FIG. 10D, an insulating material layer 405 may be formed. The insulating material layer 405 may be formed on the side surface 103b and the lower surface 102b of the light-emitting unit 100b including the recessed portions 50b. The insulating material is not particularly limited. For example, the insulating material may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. The thickness of the insulating material layer 405 may be 5 nm to 50 nm. In the present embodiment, the insulating material layer 405 may be formed of SiO₂, which is a light-transmissive insulating material. For example, the insulating material layer 405 may be formed by sputtering, ALD, PEALD, CVD, PECVD, PVD, other known methods, or a combination thereof. In the present embodiment, the light-transmissive insulating material layer 405 may be formed by ALD.

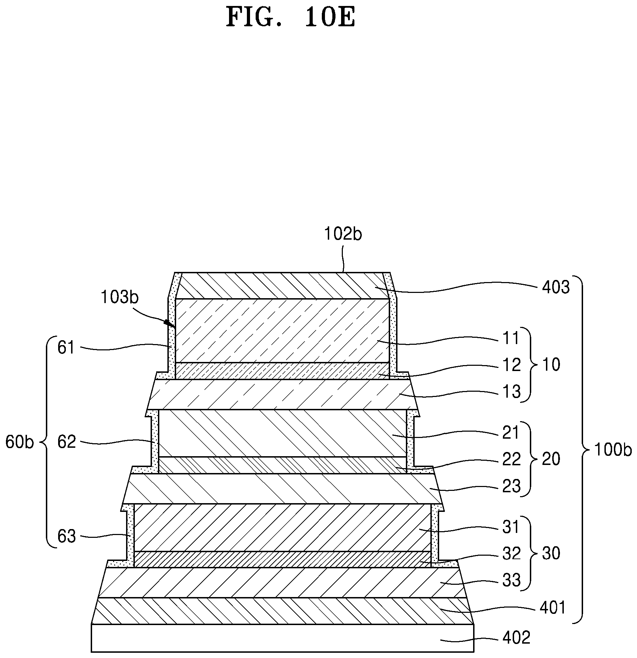

As illustrated in FIG. 10E, the insulating layers 60b including the first insulating layer 61, the second insulating layer 62, and the third insulating layer 63 may be formed by removing portions of the insulating material layer 405 formed on the side surfaces 13s, 23s, and 33s of the second conductivity-type semiconductor layers 13, 23, and 33 of the first light-emitting structure 10, the second light-emitting structure 20, and the third light-emitting structure 30, and on the lower surface 102b of the light-emitting unit 100b. This process may be performed by, for example, a dry etching process.

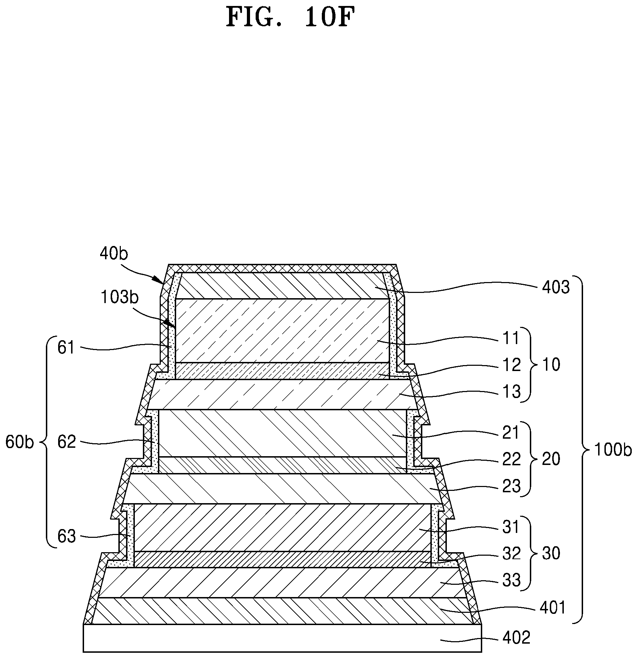

Next, a process of forming the common electrode 40b may be performed. An electrode material may be deposited on the lower surface 102b and side surface 103b of the light-emitting unit 100b. The electrode material may cover the side surfaces 13s, 23s, and 33s of the second conductivity-type semiconductor layers 13, 23, and 33 of the first light-emitting structure 10, the second light-emitting structure 20, and the third light-emitting structure 30, and the insulating layers 60b. As a result, as illustrated in FIG. 10F, the common electrode 40b may be formed in contact with the side surfaces 13s, 23s, and 33s of the second conductivity-type semiconductor layers 13, 23, and 33 of the first light-emitting structure 10, the second light-emitting structure 20, and the third light-emitting structure 30. The electrode material may include, for example, Al, Ti, Pt, Ag, Au, Pd, TiW, or various combinations thereof. The electrode material may include a transparent electrode material such as, for example, ITO. This process may be performed by, for example, sputtering, ALD, PEALD, CVD, PECVD, PVD, other known methods, or a combination thereof. In the present embodiment, the common electrode 40b may be formed by ALD.

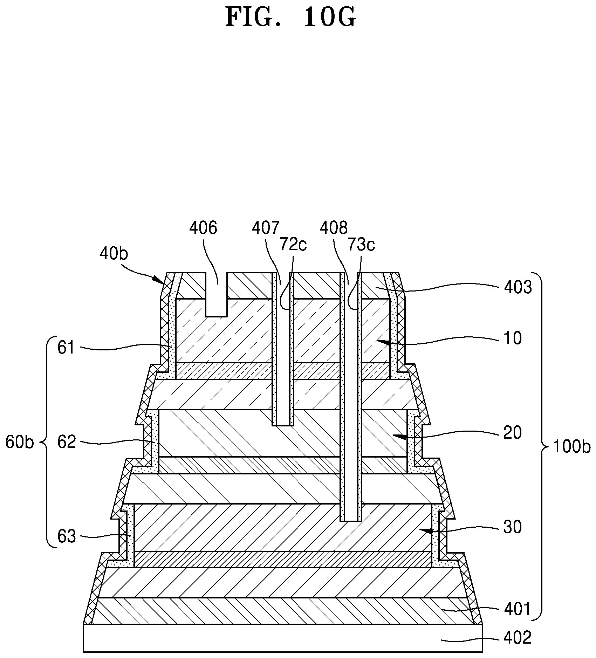

Next, a process of forming the first individual electrode 71, the second individual electrode 72, and the third individual electrode 73 will be described with reference to FIGS. 10G to 10H. First, as illustrated in FIG. 10G, a portion of the common electrode 40b formed on the upper surface of the light-transmissive insulating layer 403 may be removed, and the exposed upper surface of the light-transmissive insulating layer 403 may be polished to be planarized. Then, via holes 406, 407, and 408 may be formed. The via holes 406, 407, and 408 may be formed by an etching process. The via hole 406 may extend through the light-transmissive insulating layer 403 to the first conductivity-type semiconductor layer 11 of the first light-emitting structure 10. The via hole 406 may partially extend into the first conductivity-type semiconductor layer 11 of the first light-emitting structure 10. The via hole 407 may extend through the light-transmissive insulating layer 403 and the first light-emitting structure 10 to the first conductivity-type semiconductor layer 21 of the second light-emitting structure 20. The via hole 407 may partially extend into the first conductivity-type semiconductor layer 21 of the second light-emitting structure 20. The via hole 408 may extend through the light-transmissive insulating layer 403, the first light-emitting structure 10, and the second light-emitting structure 20 to the first conductivity-type semiconductor layer 31 of the third light-emitting structure 30. The via hole 408 may partially extend into the first conductivity-type semiconductor layer 31 of the third light-emitting structure 30.

Next, the passivation layers 72c and 73c may be formed by depositing an insulating material on inner walls of the via holes 407 and 408. The insulating material is not particularly limited and may include, for example, SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. This process may be performed by, for example, sputtering, ALD, PEALD, CVD, PECVD, PVD, other known methods, or a combination thereof. In the present embodiment, the passivation layers 72c and 73c may be formed by ALD.

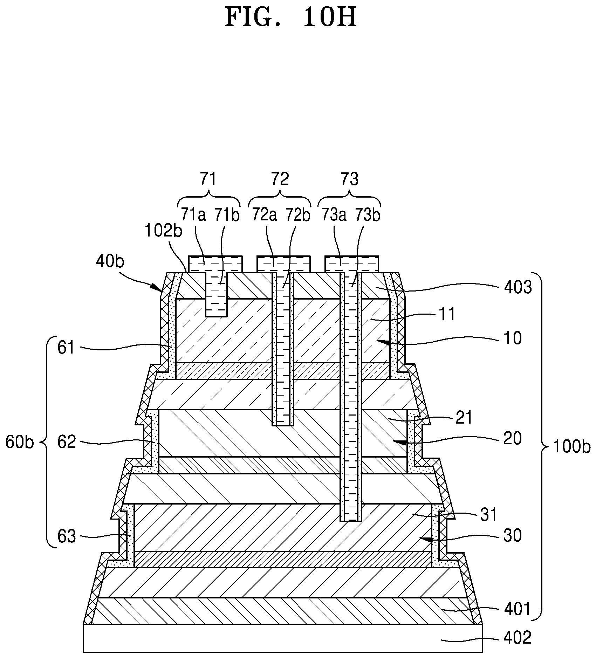

As illustrated in FIG. 10H, the first conductive via 71b, the second conductive via 72b, and the third conductive via 73b, and the first electrode pad 71a, the second electrode pad 72a, and the third electrode pad 73a respectively connected thereto and arranged on the lower surface of the light-transmissive insulating layer 403 may be formed by depositing an electrode material inside the via holes 406, 407, and 408, and on the lower surface of the light-transmissive insulating layer 403. As a result, the first individual electrode 71, the second individual electrode 72, and the third individual electrode 73 having conductive via structures may be formed on the lower surface 102b of the light-emitting unit 100b.

In the state illustrated in FIG. 10H, the light-emitting unit 100b may be flipped over and then bonded to the substrate 200 of the display panel provided with the bonding pads 201, 202, and 203 corresponding to the first individual electrode 71, the second individual electrode 72, and the third individual electrode 73, respectively. Then, the dummy substrate 402 may be removed and the light-transmissive insulating layer 401 may be planarized. The light-transmissive insulating layers 91 and 92 illustrated in FIG. 4 may be implemented by the light-transmissive insulating layers 401 and 403, respectively. As a result, the light-emitting device 1b illustrated in FIG. 4 may be manufactured.

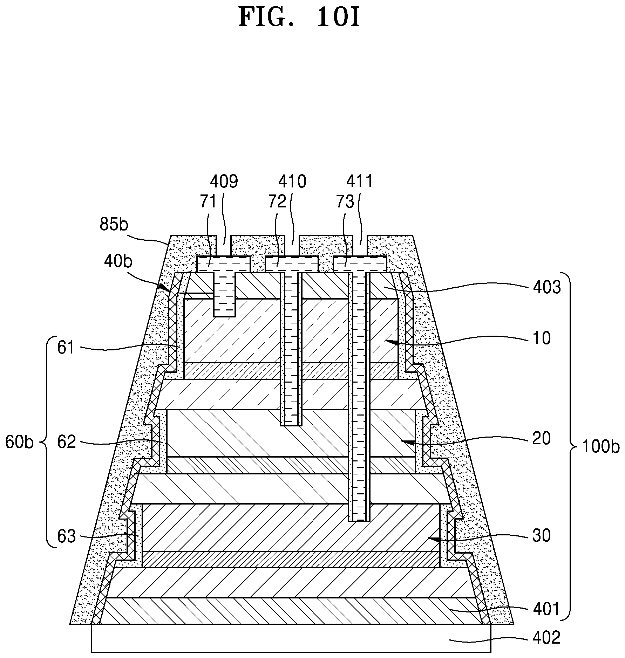

Next, a process of forming the reflective layer 80b and the passivation layer 85b will be described. After the process illustrated in FIG. 10H is performed, the first individual electrode 71, the second individual electrode 72, and the third individual electrode 73 may be partially masked, and an insulating material may be deposited on the outer peripheral surface of the light-emitting unit 100b. Then, when the mask is removed, the passivation layer 85b may be formed as illustrated in FIG. 10I. Contact holes 409, 410, and 411 may be formed in the passivation layer 85b to expose the first individual electrode 71, the second individual electrode 72, and the third individual electrode 73. The insulating material is not particularly limited and may include, for example, SiO₂, TiO₂, Si₃N₄, AlOₓ, AlOₓN_{y}, Ta₂O₅, TiN, AlN, ZrO₂, TiAlN, TiSiN, HfOₓ, or various combinations thereof. This process may be performed by, for example, sputtering, ALD, PEALD, CVD, PECVD, PVD, other known methods, or a combination thereof. In the present embodiment, the passivation layer 85b may be formed by ALD.

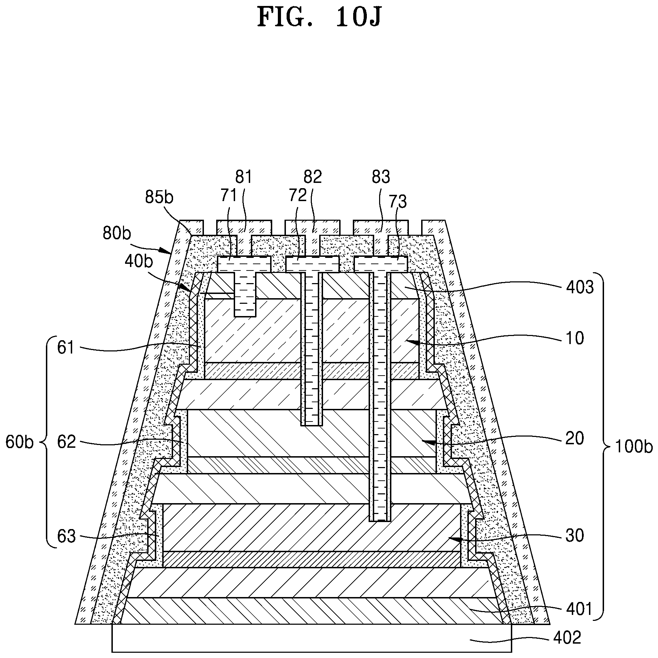

As illustrated in FIG. 10J, the reflective layer 80b may be formed by depositing a material having reflectivity such as, for example, a conductive material having reflectivity, on the outer periphery of the passivation layer 85b. For example, the conductive material may include Al, Ti, Pt, Ag, Au, Pd, TiW, or various combinations thereof. The reflective layer 80b may be electrically isolated (e.g. electrically insulated) from the common electrode 40b by the passivation layer 85b. The conductive material may fill the contact holes 409, 410, and 411. After depositing the conductive material, the conductive material layer may be patterned such that the conductive materials filled in the contact holes 409, 410, and 411 may be separated from each other. As a result, the connection pads 81, 82, and 83 for connecting the first individual electrode 71, the second individual electrode 72, and the third individual electrode 73 to the outside may be formed.

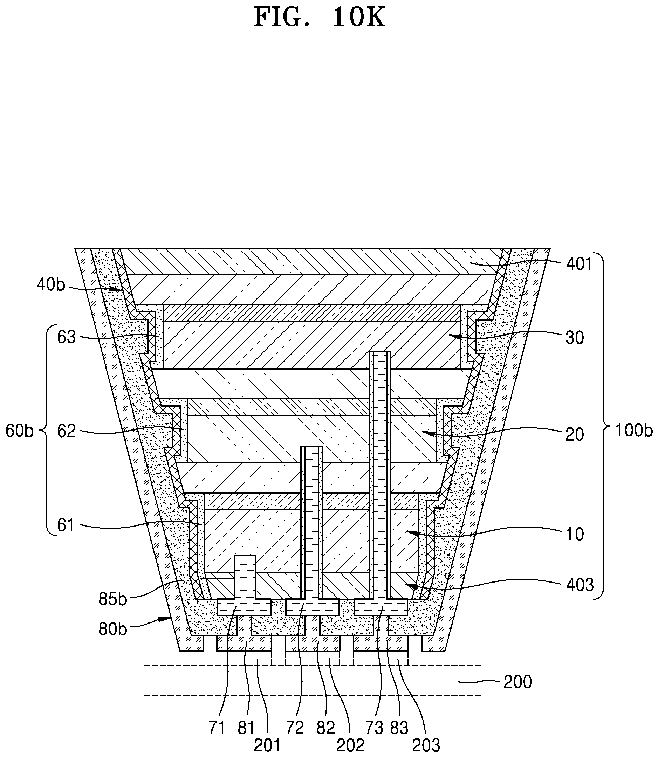

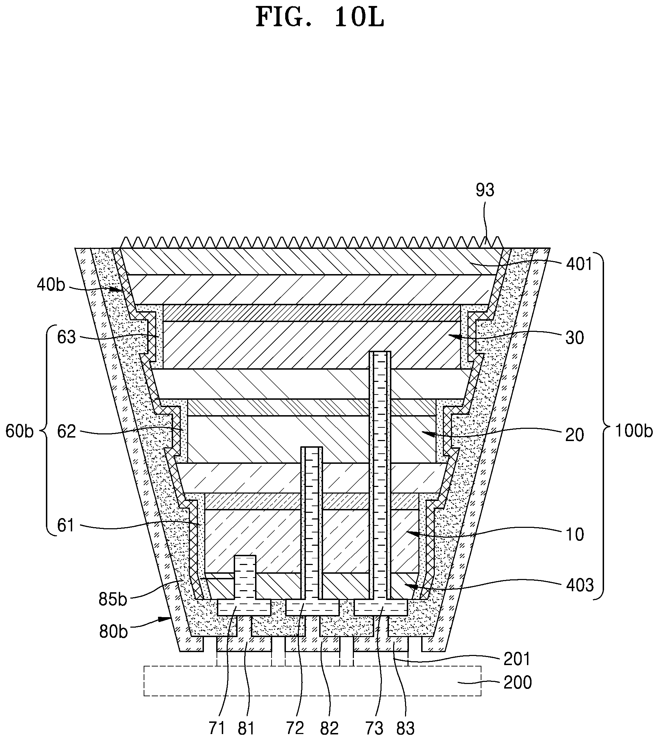

In the state illustrated in FIG. 10J, the light-emitting unit 100b may be flipped over and bonded to the substrate 200 of the display panel, and the dummy substrate 402 may be removed, as illustrated in FIG. 10K. The upper surface of the light-transmissive insulating layer 401 may be polished to be planarized. Next, as illustrated in FIG. 10L, the scattering pattern 93 may be formed on the light-transmissive insulating layer 401 by forming a light-transmissive material layer on the upper surface of the light-transmissive insulating layer 401, and etching the light-transmissive material layer with a certain concave-convex pattern. Next, the lens 90b may be formed on the light output side of the light-emitting unit 100b such as, for example, on the scattering pattern 93. The method of forming the lens 90b is not particularly limited. For example, a thermoplastic material may be deposited on the scattering pattern 93 to form a light-transmissive layer. For example, the thermoplastic material may include photoresist, polyester, acryl, epoxy, etc. The shape of the light-transmissive layer may be, for example, a cylindrical shape. Then, for example, a thermal reflow process may be performed to shape the cylindrical light-transmissive layer into, for example, a dome-shaped lens. The curvature of the lens 90b may be controlled by the surface energy of the scattering pattern 93, the contact angle of the light-transmissive layer, the thickness and width of the light-transmissive layer, the thermal reflow process temperature, etc. The light-transmissive insulating layers 91 and 92 illustrated in FIG. 4 may be implemented by the light-transmissive insulating layers 401 and 403, respectively. As a result, the light-emitting device 1c illustrated in FIG. 5 may be manufactured.

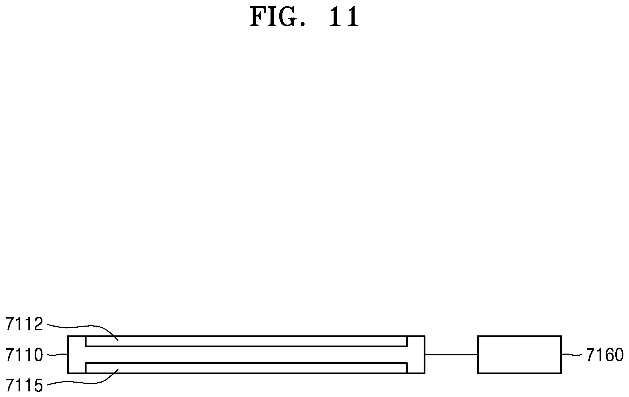

FIG. **11** is a schematic diagram of an embodiment of a display device. Referring to FIG. 11, the display device may include a display panel 7110 and a controller 7160. The display panel 7110 may have a light-emitting structure 7112 and a driver circuit 7115 that switches the light-emitting structure 7112 on and off. The light-emitting structure 7112 may include a plurality of light-emitting devices described above with reference to FIGS. 1 to 5. The plurality of light-emitting devices may be arranged in, for example, a two-dimensional array. The driver circuit 7115 may have a plurality of switching elements for individually switching the plurality of light-emitting devices on and off. The controller 7160 may input on-off switching signals for the plurality of light-emitting devices to the driver circuit 7115 according to an image signal.

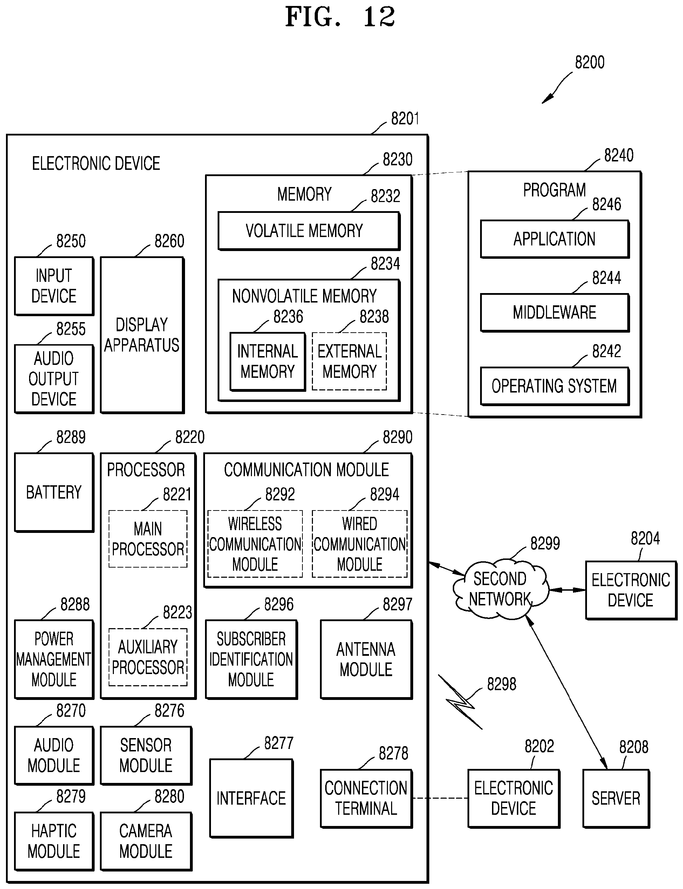

FIG. 12 is a block diagram of an embodiment of an electronic device including a display. Referring to FIG. 12, an electronic device 8201 may be provided within a network environment 8200. In the network environment 8200, the electronic device 8201 may communicate with another electronic device 8202 through a first network 8298 (e.g., a short-range wireless communication network), or may communicate with another electronic device 8204 or a server 8208 through a second network 8299 (e.g., a long-range wireless communication network). The electronic device 8201 may communicate with the electronic device 8204 via the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of these components may be omitted, or other components may be added. Some of these components may be implemented as a single integrated circuit. For example, the sensor module 8276 (e.g., a fingerprint sensor, an iris sensor, or an illuminance sensor) may be embedded in the display device 8260 (e.g., a display) to be implemented.

The processor 8220 may execute software (e.g., a program 8240) to control one or more other components (e.g., hardware or software components) of the electronic device 8201 connected to the processor 8220, and to perform various data processes or computations. As part of the data processes or computations, the processor 8220 may load commands and/or data received from other components (e.g., the sensor module 8276 or the communication module 8290) into a volatile memory 8232, process the commands and/or data stored in the volatile memory 8232, and store result data in a nonvolatile memory 8234. The processor 8220 may include a main processor 8221 (e.g., a central processing unit or an application processor) and an auxiliary processor 8223 (e.g., a graphics processing unit, an image signal processor, a sensor hub processor, or a communication processor) that may operate independently or together with the main processor 8221. The auxiliary processor 8223 may consume less power than the main processor 8221 and may perform a specialized function.

The auxiliary processor 8223 may control functions and/or states related to some of the components (e.g., the display device 8260, the sensor module 8276, or the communication module 8290) of the electronic device 8201, on behalf of the main processor 8221 while the main processor 8221 is in an inactive state (e.g., a sleep state) or together with the main processor 8221 while the main processor 8221 is in an active state (e.g., an application execution state). The auxiliary processor 8223 (e.g., an image signal processor or a communication processor) may also be implemented as part of other functionally relevant components (e.g., the camera module 8280 or the communication module 8290).

The memory 8230 may store various pieces of data used by components (e.g., the processor 8220 or the sensor module 8276) of the electronic device 8201. The data may include, for example, software (e.g., the program 8240), and input data and/or output data for commands related to the software. The memory 8230 may include the volatile memory 8232 and/or the nonvolatile memory 8234.

The program 8240 may be stored as software in the memory 8230 and may include an operating system 8242, middleware 8244, and/or an application 8246.

The input device 8250 may receive commands and/or data to be used for components (e.g., the processor 8220) of the electronic device 8201 from an external source (e.g., a user) of the electronic device 8201. The input device 8250 may include a remote controller, a microphone, a mouse, a keyboard, and/or a digital pen (e.g., a stylus pen).

The audio output device 8255 may output an audio signal to the outside of the electronic device 8201. The audio output device 8255 may include a speaker and/or a receiver. The speaker may be used for general purposes such as reproducing multimedia or recordings, and the receiver may be used to receive incoming calls. The receiver may be integrated as part of the speaker or may be implemented as a separate, independent device.

The display device 8260 may visually provide information to the outside of the electronic device 8201. The display device 8260 may include, for example, a display, a hologram device, or a projector, and a control circuit for controlling the corresponding device. The display device 8260 may include the display device described above with reference to FIG. 11. The display device 8260 may include touch circuitry configured to detect a touch, and/or sensor circuitry (e.g., a pressure sensor) configured to measure the intensity of a force generated by a touch.

The audio module 8270 may convert a sound into an electrical signal, or vice versa. The audio module 8270 may obtain sound through the input device 8250, or output sound through a speaker and/or a headphones of the audio output device 8255, and/or another electronic device (e.g., the electronic device 8202) directly or wirelessly connected to the electronic device 8201.

The sensor module 8276 may detect an operating state (e.g., power or temperature) of the electronic device 8201 or an external environmental state (e.g., a user state) and generate an electrical signal and/or a data value corresponding to the detected state. The sensor module 8276 may include a gesture sensor, a gyro sensor, a barometric sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more designated protocols, which may be used to directly or wirelessly connect the electronic device 8201 to an external electronic device (e.g., the electronic device 8202). The interface 8277 may include a High-Definition Multimedia Interface (HDMI) port, a Universal Serial Bus (USB) interface, a Secure Digital (SD) card interface, and/or an audio interface.

A connection terminal 8278 may include a connector through which the electronic device 8201 may be physically connected to another electronic device (e.g., the electronic device 8202). The connection terminal 8278 may include an HDMI connector, a USB connector, an SD card connector, and/or an audio connector (e.g., a headphone connector).

The haptic module 8279 may convert electrical signals into mechanical stimuli (e.g., vibration or movement) or electrical stimuli that the user may perceive through tactile or kinesthetic sensations. The haptic module 8279 may include a motor, a piezoelectric element, and/or an electrical stimulation device.

The camera module 8280 may capture a still image or a moving image. The camera module 8280 may include a lens assembly including one or more lenses, image sensors, image signal processors, and/or flashes. The lens assembly included in the camera module 8280 may collect light emitted from a subject to be image-captured.

The power management module 8288 may manage power supplied to the electronic device 8201. The power management module 8288 may be implemented as part of a power management integrated circuit (PMIC).

The battery 8289 may power the components of the electronic device 8201. The battery 8289 may include a non-rechargeable primary battery, a rechargeable secondary battery, and/or a fuel cell.

The communication module 8290 may support establishment of a direct (wired) communication channel and/or a wireless communication channel between the electronic device 8201 and another electronic device (e.g., the electronic device 8202, the electronic device 8204, or the server 8208), and communication through the established communication channel. The communication module 8290 may include one or more communication processors that operate independently of the processor 8220 (e.g., an application processor) and support direct communication or wireless communication. The communication module 8290 may include a wireless communication module 8292 (e.g., a cellular communication module, a short-range wireless communication module, or a global navigation satellite system (GNSS) communication module) and/or a wired communication module 8294 (e.g., a local area network (LAN) communication module or a power line communication module). The corresponding communication module may communicate with other electronic devices via the first network 8298 (e.g., a short-range communication network such as Bluetooth, Wi-Fi Direct, or Infrared Data Association (IrDA)) or the second network 8299 (e.g., a long-range communication network such as a cellular network, the Internet, or a computer network (e.g., a LAN or a wide area network (WAN)). These various types of communication modules may be integrated into a single component (e.g., a single chip) or may be implemented as a plurality of separate components (e.g., a plurality of chips). The wireless communication module 8292 may identify and authenticate the electronic device 8201 within a communication network such as the first network 8298 and/or the second network 8299, by using subscriber information (e.g., an international mobile subscriber identity (IMSI)) stored in the subscriber identification module 8296.

The antenna module 8297 may transmit or receive signals and/or power to or from the outside (e.g., another electronic device). The antenna may include a radiator made of a conductive pattern on a substrate (e.g., a printed circuit board (PCB)). The antenna module 8297 may include one or more antennas. In a case in which the antenna module 8297 includes a plurality of antennas, the communication module 8290 may select an antenna suitable for a communication scheme used in a communication network such as the first network 8298 and/or the second network 8299, from among the plurality of antennas. Signals and/or power may be transmitted or received between the communication module 8290 and other electronic devices via the selected antenna. In addition to the antennas, other components (e.g., a radio-frequency integrated circuit (RFIC)) may be included as part of the antenna module 8297.

Some of the components may be connected to each other and exchange signals (e.g., commands or data) through a communication scheme between peripheral devices (e.g., a bus, a general-purpose input/output (GPIO), Serial Peripheral Interface (SPI), or Mobile Industry Processor Interface (MIPI)).

The commands or data may be transmitted or received between the electronic device 8201 and the external device 8204 via the server 8208 connected to the second network 8299. The types of the electronic devices 8202 and 8204 may be the same as or different from the type of the electronic device 8201. All or some of the operations performed by the electronic device 8201 may be performed by one or more of the electronic devices (e.g., the electronic device 8202, the electronic device 8204, and the server 8208). For example, when the electronic device 8201 is to perform a certain function or service, the electronic device 8201 may request one or more other electronic devices to perform part or all of the function or service, instead of performing the function or service on its own. The one or more other electronic devices that has received the request may execute an additional function or service related to the request, and transmit a result of the execution to the electronic device 8201. To this end, cloud computing, distributed computing, and/or client-server computing technologies may be used.

The electronic device 8201 described above may be applied to various devices. Depending on the function of the device, various components of the electronic device 8201 described above may be appropriately modified, and components appropriate for performing the function of the device may be added. Hereinafter, example applications of the electronic device 8201 will be described.

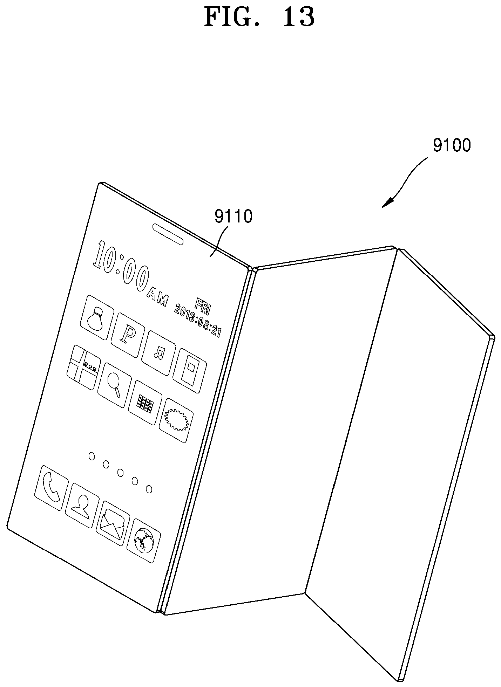

FIG. 13 illustrates an embodiment of a mobile device as an example application of an electronic device. A mobile device 9100 may include a display device 9110. The display device 9110 may include the display device described above with reference to FIG. 11. The display device 9110 may have a foldable structure such as, for example, a multi-foldable structure.

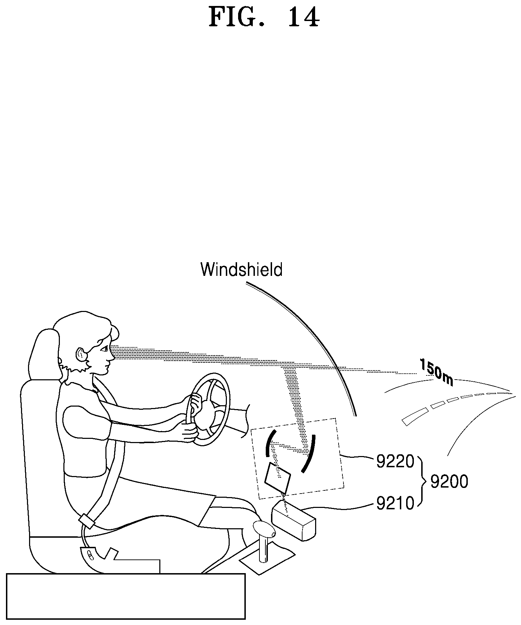

FIG. 14 illustrates an embodiment of an automotive head-up display device, an example application of an electronic device. An automotive head-up display device 9200 may include a display 9210 provided in an area of a vehicle, and an optical path changing member 9220 configured to change an optical path to allow a driver to view an image generated by the display 9210. The display 9210 may include the display device described above with reference to FIG. 11.

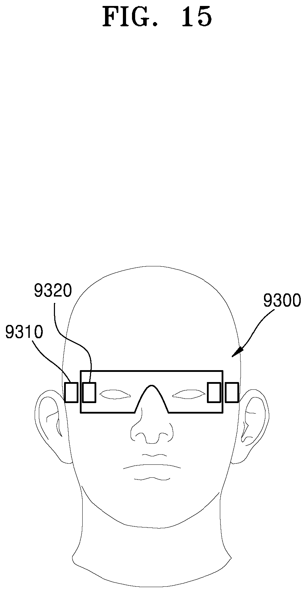

FIG. 15 illustrates an embodiment of augmented reality glasses or virtual reality glasses, an example application of an electronic device. The augmented reality glasses (or virtual reality glasses) 9300 may include a projection system 9310 configured to form an image, and an element 9320 configured to guide the image from the projection system 9310 to reach a user's eyes. The projection system 9310 may include the display device described above with reference to FIG. 11.

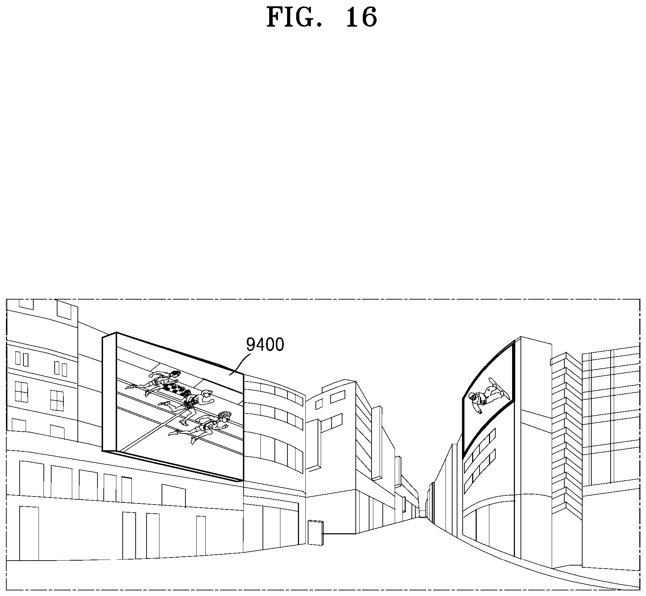

FIG. 16 illustrates an embodiment of a large signage display as an example application of an electronic device. A signage display 9400 may include the display device described above with reference to FIG. 11. The signage display 9400 may be used for outdoor advertising using digital information display, and may control advertising content, etc., through a communication network. The signage display 9400 may be implemented through, for example, the electronic device described above with reference to FIG. 12.

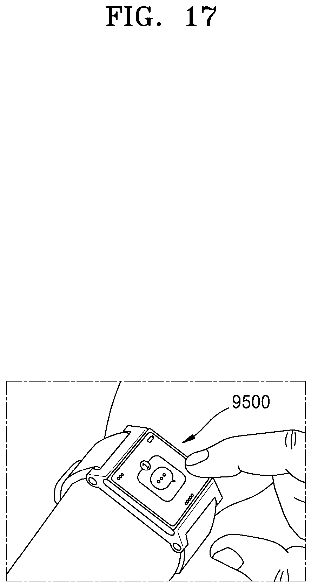

FIG. 17 illustrates an embodiment of a wearable display as an example application of an electronic device. A wearable display 9500 may include the display device described above with reference to FIG. 11. The wearable display 9500 may be implemented through the electronic device described above with reference to FIG. 12.

A light-emitting device or a display including the light-emitting device according to an embodiment may also be applied to various products such as a rollable television (TV) or a stretchable display.

Although the light-emitting devices of example embodiments of the present disclosure are described above with reference to the drawings, the embodiments are non-limiting examples, and it will be understood by one of skill in the art that various modifications and equivalent embodiments are included within the scope of the present disclosure.

According to embodiments of the present disclosure, by reducing the number of electrodes having conductive via structures, a light-emitting device with improved light emission efficiency, and a display device employing the light-emitting device, may be implemented.

It should be understood that the example embodiments described herein should be considered in a descriptive sense only and not for purposes of limitation. Descriptions of features or aspects within each embodiment should typically be considered as available for other similar features or aspects in other embodiments of the present disclosure. While one or more example embodiments have been described with reference to the figures, it will be understood by those of ordinary skill in the art that various changes in form and details may be made therein without departing from the scope of the present disclosure.

## Claims

1. A light-emitting device comprising:
a light-emitting unit comprising a first light-emitting structure, a second light-emitting structure, and a third light-emitting structure that are sequentially stacked and configured to emit light of respective, different wavelengths, wherein each of the first light-emitting structure, the second light-emitting structure, and the third light-emitting structure comprises a first conductivity-type semiconductor layer, an active layer, and a second conductivity-type semiconductor layer that are sequentially stacked;
a first individual electrode on a lower surface of the light-emitting unit and in contact with the first conductivity-type semiconductor layer of the first light-emitting structure;
a second individual electrode on the lower surface of the light-emitting unit and in contact with the first conductivity-type semiconductor layer of the second light-emitting structure;
a third individual electrode on the lower surface of the light-emitting unit and in contact with the first conductivity-type semiconductor layer of the third light-emitting structure;
a common electrode on a side surface of the light-emitting unit and in contact with side surfaces of the second conductivity-type semiconductor layer of each of the first light-emitting structure, the second light-emitting structure, and the third light-emitting structure; and
an insulating layer that insulates, from the common electrode, side surfaces of the first conductivity-type semiconductor layer and the active layer of each of the first light-emitting structure, the second light-emitting structure, and the third light-emitting structure;
wherein at least one, preferably at least two from among the first individual electrode, the second individual electrode, and the third individual electrode, comprises a conductive via structure;
**characterized in that**
the common electrode comprises a transparent electrode material.

2. The light-emitting device according to the previous claim, wherein the side surfaces of the first conductivity-type semiconductor layer and the active layer of each of the first light-emitting structure, the second light-emitting structure, and the third light-emitting structure are concavely stepped inward from the side surfaces of the second conductivity-type semiconductor layer of each of the first light-emitting structure, the second light-emitting structure, and the third light-emitting structure.

3. The light-emitting device according to the previous claim, wherein a length by which the side surfaces of the first conductivity-type semiconductor layer and the active layer of each of the first light-emitting structure, the second light-emitting structure, and the third light-emitting structure are stepped inward from the side surfaces of the second conductivity-type semiconductor layer of each of the first light-emitting structure, the second light-emitting structure, and the third light-emitting structure, is 0.5 µm or less.

4. The light-emitting device according to any one of the previous claims, wherein the common electrode surrounds said side surface of the light-emitting unit.

5. The light-emitting device according to any one of the previous claims, wherein the common electrode extends on to an upper surface of the light-emitting unit.

6. The light-emitting device according to any one of the previous claims, wherein the first individual electrode comprises a first electrode pad that is in contact with a lower surface of the first conductivity-type semiconductor layer of the first light-emitting structure,
wherein the second individual electrode comprises:
a second electrode pad that is on the lower surface of the light-emitting unit; and
a conductive via that electrically connects the second electrode pad to the first conductivity-type semiconductor layer of the second light-emitting structure, and
wherein the third individual electrode comprises:
a third electrode pad that is on the lower surface of the light-emitting unit; and
a conductive via that electrically connects the third electrode pad to the first conductivity-type semiconductor layer of the third light-emitting structure.

7. The light-emitting device according to any one of the previous claims 1-5, wherein
the first individual electrode comprises:
a first electrode pad on the lower surface of the light-emitting unit; and
a first conductive via that electrically connects the first electrode pad to the first conductivity-type semiconductor layer of the first light-emitting structure;
the second individual electrode comprises:
a second electrode pad on the lower surface of the light-emitting unit; and
a second conductive via that electrically connects the second electrode pad to the first conductivity-type semiconductor layer of the second light-emitting structure; and
the third individual electrode comprises:
a third electrode pad on the lower surface of the light-emitting unit; and
a third conductive via that electrically connects the third electrode pad to the first conductivity-type semiconductor layer of the third light-emitting structure.

8. The light-emitting device according to any one of the previous claims, further comprising:
a reflective layer that surrounds said side surface of the light-emitting unit; and
a passivation layer that insulates the common electrode from the reflective layer.

9. The light-emitting device according to any one of the previous claims, wherein said side surface of the light-emitting unit is parallel to a direction in which the first light-emitting structure, the second light-emitting structure, and the third light-emitting structure are stacked.

10. The light-emitting device according to any one of the previous claims, wherein said side surface of the light-emitting unit is inclined such as to gradually expand outward from the first light-emitting structure toward the third light-emitting structure.

11. The light-emitting device according to any one of the previous claims, further comprising a scattering pattern on an upper surface of the light-emitting unit; and/or further comprising a lens on an upper surface of the light-emitting unit.

12. The light-emitting device according to any one of the previous claims, wherein the third light-emitting structure is configured to emit red light, and wherein preferably the third light-emitting structure is the uppermost from among the first, second and third light-emitting structures.

13. The light-emitting device according to the previous claim, wherein the first light-emitting structure and the second light-emitting structure are configured to emit blue light and green light, respectively.

14. A display device comprising:
a display panel comprising:
a plurality of light-emitting devices according to any one of the previous claims;
a driver circuit configured to switch the plurality of light-emitting devices on and off; and
a controller configured to input on-off switching signals for the plurality of light-emitting devices to the driver circuit according to an image signal.

## Amended claims

### Amended claims in accordance with Rule 137(2) EPC.

1. A light-emitting device comprising:
a light-emitting unit comprising a first light-emitting structure, a second light-emitting structure, and a third light-emitting structure that are sequentially stacked and configured to emit light of respective, different wavelengths, wherein each of the first light-emitting structure, the second light-emitting structure, and the third light-emitting structure comprises a first conductivity-type semiconductor layer, an active layer, and a second conductivity-type semiconductor layer that are sequentially stacked;
a first individual electrode on a lower surface of the light-emitting unit and in contact with the first conductivity-type semiconductor layer of the first light-emitting structure;
a second individual electrode on the lower surface of the light-emitting unit and in contact with the first conductivity-type semiconductor layer of the second light-emitting structure;
a third individual electrode on the lower surface of the light-emitting unit and in contact with the first conductivity-type semiconductor layer of the third light-emitting structure;
a common electrode on a side surface of the light-emitting unit and in contact with side surfaces of the second conductivity-type semiconductor layer of each of the first light-emitting structure, the second light-emitting structure, and the third light-emitting structure; and
an insulating layer that insulates, from the common electrode, side surfaces of the first conductivity-type semiconductor layer and the active layer of each of the first light-emitting structure, the second light-emitting structure, and the third light-emitting structure;
wherein at least one, preferably at least two from among the first individual electrode, the second individual electrode, and the third individual electrode, comprises a conductive via structure;
**characterized in that**
the common electrode comprises a transparent electrode material.

2. The light-emitting device according to the previous claim, wherein the side surfaces of the first conductivity-type semiconductor layer and the active layer of each of the first light-emitting structure, the second light-emitting structure, and the third light-emitting structure are concavely stepped inward from the side surfaces of the second conductivity-type semiconductor layer of each of the first light-emitting structure, the second light-emitting structure, and the third light-emitting structure.

3. The light-emitting device according to the previous claim, wherein a length by which the side surfaces of the first conductivity-type semiconductor layer and the active layer of each of the first light-emitting structure, the second light-emitting structure, and the third light-emitting structure are stepped inward from the side surfaces of the second conductivity-type semiconductor layer of each of the first light-emitting structure, the second light-emitting structure, and the third light-emitting structure, is 0.5 µm or less.

4. The light-emitting device according to any one of the previous claims, wherein the common electrode surrounds said side surface of the light-emitting unit.

5. The light-emitting device according to any one of the previous claims, wherein the common electrode extends on to an upper surface of the light-emitting unit.

6. The light-emitting device according to any one of the previous claims, wherein the first individual electrode comprises a first electrode pad that is in contact with a lower surface of the first conductivity-type semiconductor layer of the first light-emitting structure,
wherein the second individual electrode comprises:
a second electrode pad that is on the lower surface of the light-emitting unit; and
a conductive via that electrically connects the second electrode pad to the first conductivity-type semiconductor layer of the second light-emitting structure, and
wherein the third individual electrode comprises:
a third electrode pad that is on the lower surface of the light-emitting unit; and
a conductive via that electrically connects the third electrode pad to the first conductivity-type semiconductor layer of the third light-emitting structure.

7. The light-emitting device according to any one of the previous claims 1-5, wherein
the first individual electrode comprises:
a first electrode pad on the lower surface of the light-emitting unit; and
a first conductive via that electrically connects the first electrode pad to the first conductivity-type semiconductor layer of the first light-emitting structure;
the second individual electrode comprises:
a second electrode pad on the lower surface of the light-emitting unit; and
a second conductive via that electrically connects the second electrode pad to the first conductivity-type semiconductor layer of the second light-emitting structure; and
the third individual electrode comprises:
a third electrode pad on the lower surface of the light-emitting unit; and
a third conductive via that electrically connects the third electrode pad to the first conductivity-type semiconductor layer of the third light-emitting structure.

8. The light-emitting device according to any one of the previous claims, further comprising:
a reflective layer that surrounds said side surface of the light-emitting unit; and
a passivation layer that insulates the common electrode from the reflective layer.

9. The light-emitting device according to any one of the previous claims, wherein said side surface of the light-emitting unit is parallel to a direction in which the first light-emitting structure, the second light-emitting structure, and the third light-emitting structure are stacked.

10. The light-emitting device according to any one of the previous claims, wherein said side surface of the light-emitting unit is inclined such as to gradually expand outward from the first light-emitting structure toward the third light-emitting structure.

11. The light-emitting device according to any one of the previous claims, further comprising a scattering pattern on an upper surface of the light-emitting unit; and/or further comprising a lens on an upper surface of the light-emitting unit.

12. The light-emitting device according to any one of the previous claims, wherein the third light-emitting structure is configured to emit red light, and wherein preferably the third light-emitting structure is the uppermost from among the first, second and third light-emitting structures.

13. The light-emitting device according to the previous claim, wherein the first light-emitting structure and the second light-emitting structure are configured to emit blue light and green light, respectively.

14. A display device comprising:
a display panel comprising:
a plurality of light-emitting devices according to any one of the previous claims;
a driver circuit configured to switch the plurality of light-emitting devices on and off; and
a controller configured to input on-off switching signals for the plurality of light-emitting devices to the driver circuit according to an image signal.
